(19) Europäisches Patentamt
European Patent Office
Office européen des brevets

(11) **EP 2 100 245 B1**

(12) **FASCICULE DE BREVET EUROPEEN**

(45) Date de publication et mention
de la délivrance du brevet:
**18.05.2011 Bulletin 2011/20**

(21) Numéro de dépôt: **07872425.9**

(22) Date de dépôt: **20.12.2007**

(51) Int Cl.:
*G06F 17/50* (2006.01)       *B60C 19/00* (2006.01)
*G01M 17/02* (2006.01)

(86) Numéro de dépôt international:
**PCT/FR2007/002141**

(87) Numéro de publication internationale:
**WO 2008/096068 (14.08.2008 Gazette 2008/33)**

(54) **PROCÈDE POUR SÉLECTIONNER UNE CONFIGURATION OPTIMISÉE DE PNEUMATIQUES POUR UN VÉHICULE TERRESTRE TEL QU'UNE VOITURE OU UNE MOTO DE COMPÉTITION**

VERFAHREN ZUR AUSWAHL DER OPTIMALEN REIFENKONFIGURATION FÜR EIN STRASSENFAHRZEUG, WIE Z. B. EIN RENNAUTO ODER EIN MOTORRAD

METHOD FOR SELECTING AN OPTIMISED TYRE CONFIGURATION FOR A ROAD VEHICLE SUCH AS A RACING CAR OR MOTORCYCLE

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **26.12.2006 FR 0611362**

(43) Date de publication de la demande:
**16.09.2009 Bulletin 2009/38**

(73) Titulaires:
• **Société de Technologie MICHELIN**
  **63000 Clermont-Ferrand (FR)**
• **MICHELIN Recherche et Technique S.A.**
  **1763 Granges-Paccot (CH)**

(72) Inventeurs:
• **MARTIN, Hervé**
  **8003 Zürich (CH)**
• **ZIVKOVIC, Tony**
  **FR-63000 Clermont-Ferrand (FR)**

(74) Mandataire: **Dequire, Philippe Jean-Marie Denis et al**
**M.F.P. Michelin**
**23, place des Carmes-Déchaux**
**SGD/LG/PI-F35-Ladoux**
**63040 Clermont-Ferrand Cedex 09 (FR)**

(56) Documents cités:
**EP-A- 0 892 263        EP-A- 1 516 751**
**EP-A- 1 627 751        US-A1- 2004 068 391**
**US-A1- 2006 282 197**

## Description

L'invention concerne, de façon générale, les techniques liées à' l'équipement en pneumatiques des véhicules à moteurs.

Plus précisément, l'invention concerne un procédé pour sélectionner, parmi un ensemble de configurations possibles, une configuration optimisée de pneumatiques pour équiper un véhicule destiné à courir sur un circuit en suivant une trajectoire prédéterminée, orientée dans un sens unique de parcours et incluant des virages.

Cette sélection, qui est traditionnellement réalisée sur la base d'essais et de résultats d'expériences, représente aujourd'hui des investissements considérables en termes de temps et d'argent.

Note aussi que le brevet américaine US2006/282197 divulgue un procédé de simulation d'un voiture destiné à courir sur un circuit comprenant un modèle du voiture entière et la simulation par itération d'un parcours, par le véhicule modélisé, les données requises pour obtenir des paramètres dudit modèle étant acquises sur un voiture réelle.

Néanmoins, même dans le cas où ces investissements peuvent être réalisés, ce mode de sélection présente l'inconvénient qu'il ne peut être mis en oeuvre qu'après fabrication des pneus utilisés pour les essais.

La présente invention a précisément pour but de proposer un procédé de sélection exempt de cette contrainte.

A cette fin, le procédé de l'invention, par ailleurs conforme à la définition qu'en donne le préambule ci-dessus, est essentiellement caractérisé en que qu'il comprend au moins les étapes mises en oeuvre sur un ordinateur et consistant à :

- développer un modèle physique du véhicule équipé d'une première configuration de pneus;
- découper une image numérique de la trajectoire en tronçons successifs se raccordant en des points auxquels sont associées des valeurs limites de la vitesse du véhicule;
- simuler par itérations le parcours, par le véhicule modélisé, de chaque tronçon de trajectoire, d'abord en accélération maximale sur des portions de trajectoire prises successivement dans le sens de parcours réel et appartenant à une première partie de tronçon incluant un point initial de ce tronçon, puis en décélération maximale sur des portions de trajectoire prises successivement en amont les unes des autres et appartenant à une deuxième partie de tronçon incluant un point terminal de ce tronçon, et en raccordant les première et deuxième parties de tronçon en un point du tronçon où la vitesse du véhicule modélisé sur la première partie de ce tronçon ne dépasse pas la vitesse du véhicule modélisé sur la deuxième partie de ce tronçon;
- mémoriser le temps de parcours mis par le véhicule pour parcourir au moins une fois la trajectoire;
- comparer le temps de parcours à au moins un temps de référence et produire un résultat de comparaison; et
- sélectionner ou non la première configuration comme configuration optimisée en fonction du résultat de comparaison.

Dans un mode de réalisation préféré de l'invention, le modèle du véhicule inclut un modèle thermomécanique des pneus équipant ce véhicule.

Ce procédé peut notamment comprendre les étapes consistant à :

(a) recenser un ensemble de paramètres physiques tendant à limiter la vitesse adoptée par le véhicule sur la trajectoire, cet ensemble comprenant des paramètres constants et des paramètres dynamiques, ces paramètres étant liés aux différents pneus possibles, au châssis du véhicule et/ou aux conditions de roulement, et incluant une image numérique de la trajectoire, constituée par des coordonnées numérisées de points successifs de cette trajectoire;

(b) développer un modèle de pneu décrivant le comportement physique de chaque pneu et faisant intervenir un premier sous-ensemble de l'ensemble des paramètres physiques;

(c) développer un modèle de véhicule faisant intervenir à la fois le modèle de pneu et un deuxième sous-ensemble de l'ensemble des paramètres physiques, et décrivant le comportement physique du véhicule en fonction au moins de sollicitations des pneus, ces sollicitations comprenant des glissements et des dérives;

(d) découper l'image numérique de la trajectoire en tronçons adjacents se succédant dans le sens de parcours et dont chacun comprend un ensemble d'au moins trois points de trajectoire incluant un point initial et un point terminal de ce tronçon se succédant dans cet ordre dans le sens de parcours, le point terminal étant localisé dans une entrée de virage;

(e) associer respectivement aux points initial et terminal de chaque tronçon des valeurs limites de la vitesse du véhicule;

(f) sélectionner, en tant que configuration active, une première configuration de pneus;

(g) sélectionner, en tant que tronçon actif, un premier tronçon de trajectoire;

(h) simuler, au moyen du modèle de véhicule, lue parcours d'une première partie au moins du tronçon actif de trajectoire, depuis son point initial, par le véhicule équipé de la configuration active de pneus, en optimisant les sollicitations des pneus pour maximiser l'accélération subie par le véhicule à partir de la vitesse limite associée au point initial de ce tronçon actif;

(i) mémoriser les vitesses du véhicule aux différents points de la première partie du tronçon actif et les temps de parcours entre ces différents points;

(j) sélectionner, en tant que section active du tronçon actif, la portion de trajectoire définie entre un premier et un deuxième points d'une paire de points du tronçon actif se succédant dans cet ordre dans le sens de parcours, le deuxième point de cette paire étant constitué par le point terminal du tronçon actif;

(k) sélectionner, en tant que vitesse cible, la vitesse limite associée au deuxième point de la section active;

(1) simuler, au moyen du modèle de véhicule, le parcours de la section active du tronçon actif par le véhicule équipé de la configuration active de pneus, en optimisant les sollicitation des pneus et la vitesse adoptée par le véhicule au premier point de la section active pour atteindre le deuxième point de la section active à la vitesse cible, tout en minimisant le temps de parcours sur cette section active;

(m) mémoriser le temps de parcours de la section active par le véhicule; mémoriser, en tant que vitesse limite, la vitesse du véhicule au premier point de la section active; et mémoriser, en tant qu'élément d'une deuxième partie du tronçon actif, la section active parcourue;

(n) vérifier si la vitesse limite du véhicule au premier point de la section active dépasse ou non la vitesse, mémorisée à l'étape (i), qui est adoptée en ce même point par le véhicule lors du parcours de la première partie du tronçon actif;

(o) dans la négative, sélectionner, en tant que nouvelle section active du tronçon actif, une portion de trajectoire située en amont, par rapport au sens de parcours, de la section active chronologiquement précédente, et définie entre un premier et un deuxième points d'une paire de points du tronçon actif se succédant dans cet ordre dans le sens de parcours, le deuxième point de cette paire étant constitué par le premier point de la section active chronologiquement précédente, et répéter les étapes (k) à (n);

(p) dans l'affirmative, mémoriser, en tant que temps de parcours total du tronçon actif, la somme du temps de parcours total sur la deuxième partie de ce tronçon actif et des temps de parcours mémorisés sur la fraction de la première partie de ce tronçon qui ne recouvre pas la deuxième partie;

(q) sélectionner, en tant que nouveau tronçon actif, le tronçon de trajectoire qui succède au tronçon précédemment actif dans le sens de parcours;

(r) répéter les étapes (h) à (q) jusqu'à parcourir au moins une fois la trajectoire et obtenir un temps de parcours cumulé et stabilisé de la trajectoire par le véhicule.

Il est possible de prévoir que le temps de référence soit obtenu en appliquant le procédé de l'invention à une autre configuration de pneus, auquel cas de procédé comprend en outre les étapes consistant à :

(s) sélectionner, en tant que nouvelle configuration active, une deuxième configuration de pneus;

(t) répéter les étapes (g) à (r);

(u) comparer les temps de parcours cumulés et stabilisés de la trajectoire, respectivement obtenus avec les première et deuxième configurations de pneus; et

(v) sélectionner, en tant que configuration optimisée, la configuration de pneus conduisant au plus court temps de parcours cumulé et stabilisé de la trajectoire, le temps de parcours obtenu avec chaque configuration de pneus servant ainsi de temps de référence pour le temps de parcours obtenu avec l'autre configuration de pneus.

Dans le cas où le modèle de pneu est un modèle thermomécanique, il est possible de prévoir que l'étape (j) soit précédée d'une étape (w0) consistant à sélectionner, en tant que conditions thermiques actives, des conditions thermiques prédéterminées, que l'étape (1) soit réalisée en appliquant aux pneus les conditions thermiques actives, que l'étape (m) inclue l'opération élémentaire supplémentaire qui consiste à mémoriser les sollicitations des pneus sur chaque section active, et que l'étape (p) soit immédiatement précédée d'une boucle d'itération comprenant les étapes consistant à :

(w1) en cas de succès de la vérification réalisée à l'étape (n), simuler au moyen du modèle de véhicule le parcours par ce véhicule équipé de la configuration active de pneus, section active après section active dans le sens de parcours, de la deuxième partie du tronçon actif, en appliquant aux pneus sur chaque section active les sollicitations mémorisées à l'étape (m) pour cette section active, et en déduire de nouvelles conditions thermiques d'utilisation des pneus sur la deuxième partie du tronçon actif;

(w2) vérifier si l'écart entre les nouvelles conditions thermiques et les conditions thermiques actives s'inscrit ou non dans une limite de convergence; et

(w3) dans la négative, mémoriser, en tant que conditions thermiques actives, les nouvelles conditions thermiques et répéter les étapes (j) à (w2).

L'étape (d) peut être mise en oeuvre en fixant le point terminal de chaque tronçon au maximum de courbure d'un virage, et le procédé de l'invention peut comprendre une opération supplémentaire, mise en oeuvre à chaque nouveau parcours de la trajectoire et consistant à déplacer le point terminal de chaque tronçon vers l'amont, en direction d'une zone de moindre glissement des pneus.

Le procédé de l'invention peut être optimisé en prévoyant que le modèle de pneu développé à l'étape (b) et mis en oeuvre à chaque étape de simulation (h, 1, w1) décrive le comportement physique de chaque pneu équipant le véhicule en situation de roulement sur le sol, avec lequel la bande de roulement du pneu présente une aire de contact incluant au moins une zone de contact adhérent et au moins une zone de contact glissant, que l'étape (b) comprenne au moins des opérations de modélisation, que chaque étape de simulation (h, 1, w1) comprenne des opérations d'affectation de valeurs numériques et des opérations de résolution, que les opérations de modélisation consistent au moins à établir, par application de lois physiques connues et / ou construites par expérimentation spécifique, et en tant que premier modèle, un modèle des efforts longitudinaux, des efforts transversaux, et d'un couple d'auto-alignement, transmis par le pneu entre le sol et le véhicule, en fonction de paramètres physiques spécifiques, incluant un coefficient d'adhérence et un module de cisaillement de la gomme du pneu, et en fonction de paramètres dynamiques liés aux conditions physiques de roulement et d'utilisation du pneu, le couple d'auto-alignement étant lié à l'intensité des efforts longitudinaux et transversaux et à leur distribution dans l'aire de contact, en prévoyant que les opérations d'affectation consistent au moins à attribuer des valeurs numériques aux paramètres dynamiques et aux paramètres spécifiques, et que les opérations de résolution consistent au moins à déduire, en utilisant au moins le premier modèle et les valeurs attribuées aux paramètres dynamiques et aux paramètres physiques spécifiques, des valeurs des efforts longitudinaux, des efforts transversaux, et du couple d'auto-alignement, en prévoyant que les opérations de modélisation comprennent aussi l'établissement, en tant que second modèle, d'un modèle local d'échauffement exprimant des variations d'une température de contact de la bande de roulement avec le sol depuis l'entrée jusqu'à la sortie de l'aire de contact par suite du contact et du glissement de la bande de roulement avec le sol, et l'établissement, en tant que troisième modèle, d'un modèle global d'échauffement et de flux thermique, ce troisième modèle exprimant des variations, sur une période d'au moins un tour de roue, d'une température périphérique de la bande de roulement et d'une température interne du pneu en fonction de valeurs antérieurement connues ou estimées des températures périphérique et interne, d'un coefficient de conduction thermique de la bande de roulement, et de phénomènes à composante thermodynamique tels que déformations internes subies par le pneu, échanges thermiques entre le pneu et son environnement, et glissement de la bande de roulement sur le sol, et en prévoyant qu'au moins le coefficient d'adhérence et le module de cisaillement interviennent dans le premier modèle comme des variables respectivement fonctions de la température périphérique et de la température interne, que la valeur de la température périphérique, obtenue par des opérations de résolution afférentes au troisième modèle, soit utilisée par des opérations de résolution afférentes au deuxième modèle pour prendre en compte la dépendance en température du coefficient d'adhérence, et que la valeur de la température interne, obtenue par des opérations de résolution afférentes au troisième modèle, soit utilisée par des opérations de résolution afférentes au premier modèle pour prendre en compte la dépendance en température du module de cisaillement de la gomme du pneu.

Il est avantageux de prévoir que le premier modèle développé à l'étape (b) comprenne des équations liées à des conditions d'équilibre des forces élémentaires de cisaillement et de glissement de la bande de roulement dans l'aire de contact, que chaque étape de simulation (h, l, w1) comprenne au moins une phase itérative de calcul constituée d'une succession de cycles de calcul, et que chaque cycle de calcul comprenne au moins une opération de résolution afférente au premier modèle et une opération de résolution afférente au deuxième modèle.

Le procédé de l'invention, dans un mode préféré de réalisation, peut être mis en oeuvre en prévoyant dans l'étape (b) que le premier modèle soit établi en considérant que l'aire de contact comprend une unique zone de contact adhérent et une unique zone de contact glissant séparées l'un de l'autre par un point de passage, que le premier modèle prenne la forme d'un système d'équations exprimées au moins en fonction des paramètres dynamiques, des paramètres spécifiques, et de l'abscisse du point de passage, que chaque phase itérative soit dédiée à des phénomènes apparaissant pendant un intervalle de temps élémentaire correspondant, et que chaque phase itérative soit mise en oeuvre pour résoudre, par approximations successives et au moins à partir de valeurs antérieurement connues ou estimées de l'abscisse du point de passage, des efforts transversaux, et du couple d'auto-alignement, de nouvelles valeurs de l'abscisse du point de passage, des efforts transversaux, et du couple d'auto-alignement qui résolvent le système d'équations du premier modèle pour les valeurs attribuées aux paramètres dynamiques et aux paramètres spécifiques, ce dont il résulte que les efforts longitudinaux, les efforts transversaux, et le couple d'auto-alignement du pneu peuvent être calculés en temps réel pendant le roulement du véhicule.

Dans ce cas, chaque nouveau cycle de calcul de chaque phase itérative comprend de préférence les opérations consistant au moins à :

- calculer une nouvelle valeur provisoire de l'abscisse du point de passage à partir des équations d'équilibre des forces élémentaires et des valeurs antérieurement connues ou estimées des efforts transversaux et du couple d'auto-alignement;

- calculer, à partir de la nouvelle valeur provisoire de l'abscisse du point de passage et des équations liant les efforts transversaux et le couple d'auto-alignement aux paramètres dynamiques, aux paramètres spécifiques, et à l'abscisse du point de passage, de nouvelles valeurs des efforts transversaux et du couple d'auto-alignement utilisables pour un éventuel cycle de calcul ultérieur;
- interrompre conditionnellement ladite phase itérative au moins lorsque l'écart entre la nouvelle valeur provisoire de l'abscisse du point de passage et la valeur antérieurement connue ou estimée de cette abscisse est inférieur à une limite de précision prédéterminée; et
- à l'interruption de ladite phase itérative, affecter aux efforts transversaux et au couple d'auto-alignement, en tant que valeurs pour cette phase, les nouvelles valeurs des efforts transversaux et du couple d'auto-alignement obtenues au dernier cycle de calcul.

En outre, chaque étape de simulation (h, 1, w1) du véhicule intervenant dans le procédé de l'invention comprend alors avantageusement une opération mise en oeuvre après la fin de chaque phase itérative et consistant à mettre au moins à jour les paramètres dynamiques pour tenir compte des évolutions subies par ces paramètres pendant le temps d'exécution de la phase itérative, et à engager une nouvelle phase itérative.

Par ailleurs, les opérations de résolution afférentes au troisième modèle sont de préférence effectuées en dehors de chaque phase itérative.

Chaque phase itérative peut être précédée d'une phase préparatoire au cours de laquelle sont calculées des grandeurs contingentes, incluant les dimensions de l'aire de contact, en fonction des valeurs attribuées aux paramètres dynamiques et aux paramètres spécifiques, chaque grandeur contingente étant exploitée dans ladite phase itérative avec une valeur qui lui a été attribuée lors de la phase préparatoire.

Pour modéliser le véhicule dans son ensemble, il est possible de prévoir que chacun des premier, deuxième et troisième modèles soit exploité pour chaque pneu et associé à un modèle dynamique de châssis, que le modèle de châssis fournisse aux premier, deuxième et troisième modèles, pour chaque pneu, les valeurs de certains au moins des paramètres dynamiques, et que le modèle de châssis exploite, pour chaque pneu, les valeurs des efforts longitudinaux, des efforts transversaux, et du couple d'auto-alignement obtenues par la mise en oeuvre des premier, deuxième et troisième modèles.

D'autres caractéristiques et avantages de l'invention ressortiront clairement de la description qui en est faite ci-après, à titre indicatif et nullement limitatif, en référence aux dessins annexés, dans lesquels :

- la figure 1 est une vue schématique d'un exemple de trajectoire possible, constitué par le circuit de compétition automobile de Jerez;
- la figure 2 est un organigramme illustrant l'organisation opératoire globale du procédé de l'invention;
- la figure 3 est une vue schématique agrandie d'une partie du circuit illustré à la figure 1;
- la figure 4 est un diagramme représentant, en fonction de la distance parcourue par le véhicule et repérée en abscisse, la vitesse adoptée par ce véhicule et repérée en ordonnées, d'une part pour la première partie d'un tronçon actif, et d'autre part pour la deuxième partie de ce tronçon;
- la figure 5 est une vue schématique en élévation d'une roue équipée d'un pneu auquel est appliqué un modèle de pneu utilisable dans le procédé de l'invention;
- la figure 6 est une vue schématique de dessus agrandie de l'aire de contact du pneu de la figure 5 avec le sol, le pneu étant en situation de dérive par rapport au vecteur vitesse (axe X);
- la figure 7 est une vue schématique de face du pneu de la figure 5, le pneu étant en situation de carrossage ;
- la figure 8 est une vue schématique partielle et en coupe radiale d'un pneu représenté dans deux situations différentes de sollicitations;
- la figure 9 est une vue schématique en élévation d'un pneu représenté dans deux situations différentes de sollicitations;
- la figure 10 est une vue schématique de dessus d'un pneu subissant une torsion;
- la figure 11 est un schéma récapitulant les différentes grandeurs intervenant dans la mise en oeuvre du procédé de l'invention;
- la figure 12 est une vue schématique de dessus d'un pneu subissant diverses sollicitations;
- la figure 13 est une vue de dessus agrandie de l'aire de contact d'un pneu subissant diverses sollicitations, et sur laquelle apparaissent la trace de points et de trajectoires caractéristiques;
- la figure 14 représente, de façon tridimensionnelle, la loi liant le coefficient d'adhérence à la température de contact, et à la vitesse de glissement d'un pneu, pour une pression de contact donnée;
- la figure 15 représente la loi liant à la température le module de cisaillement du mélange caoutchouc de la bande de roulement d'un pneu, pour un niveau donné de sollicitation en fréquence et déformation;
- la figure 16 est un schéma récapitulant les phénomènes thermiques pris en compte dans le modèle thermique global du pneu;

- la figure 17 est un organigramme illustrant la structure opérationnelle du modèle de pneu préféré utilisable dans le procédé de l'invention;
- les figures 18a et 18b sont des organigrammes illustrant la structure opérationnelle d'un autre modèle de pneu préféré utilisable dans le procédé de l'invention; et
- la figure 19 est un schéma illustrant le fonctionnement d'un véhicule bicycle en régime permanent.

Comme annoncé précédemment, l'invention concerne un procédé permettant de sélectionner, parmi un ensemble de configurations possibles, une configuration optimisée de pneumatiques pour équiper un véhicule.

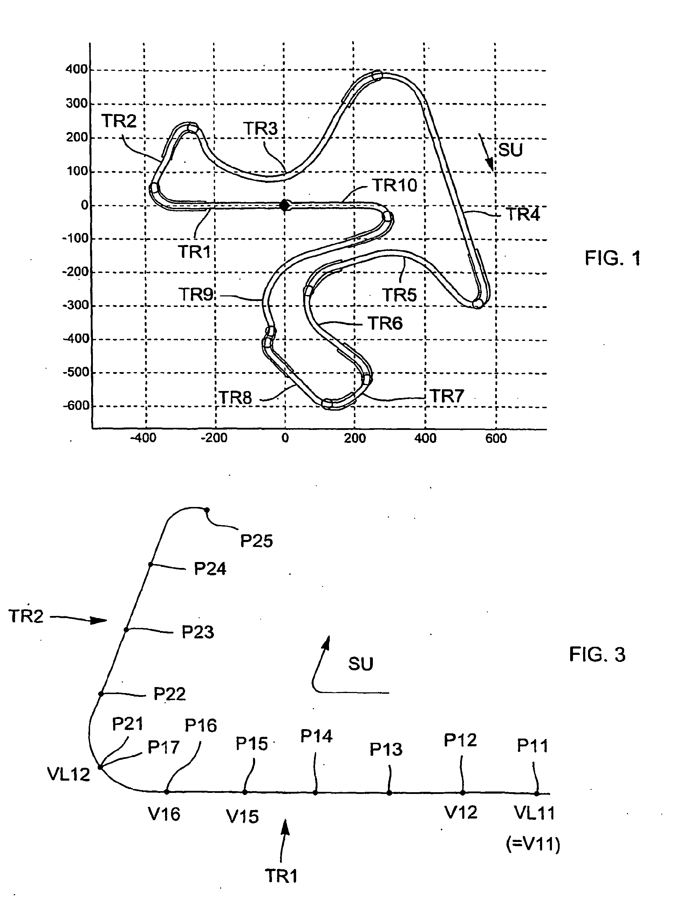

L'invention s'applique en particulier à l'équipement en pneus d'un véhicule de compétition destiné à courir sur un circuit tel qu'illustré à la figure 1 en suivant une trajectoire prédéterminée, cette trajectoire étant orientée dans un sens unique de parcours SU et incluant des virages.

Ce procédé requiert le développement d'un modèle physique du véhicule équipé d'une configuration de pneus, impliquant une modélisation de ces pneumatiques et permettant une simulation du véhicule équipé de ces pneus.

Une fois disponibles les modèles des pneumatiques et du véhicule, le procédé de l'invention réalise une simulation du parcours de la trajectoire par le véhicule modélisé, dans laquelle la vitesse du véhicule est optimisée.

Le temps de parcours mis par le véhicule pour parcourir au moins une fois la trajectoire est alors mémorisé et comparé à un temps de référence.

Il est ainsi possible, en fonction du résultat de cette comparaison, d'évaluer par rapport à une référence la configuration de pneus utilisée dans la simulation, et donc de classer cette configuration comme étant ou non optimisée par rapport à la référence.

Cette référence peut elle-même être constituée par une configuration de pneus équipant un véhicule simulé, de sorte que deux configurations différentes de pneus peuvent servir de référence l'une par rapport à l'autre.

Dans le mode de réalisation préféré de l'invention, le modèle utilisé pour les pneus est un modèle thermomécanique, la simulation pouvant ainsi atteindre un haut degré de réalisme.

Un exemple détaillé de mise en oeuvre du procédé de l'invention est donné ci-après dans le cas le plus complet, dans lequel la référence est constituée par une configuration de pneus ayant fait l'objet d'une simulation, et dans lequel le modèle de pneus est un modèle thermomécanique.

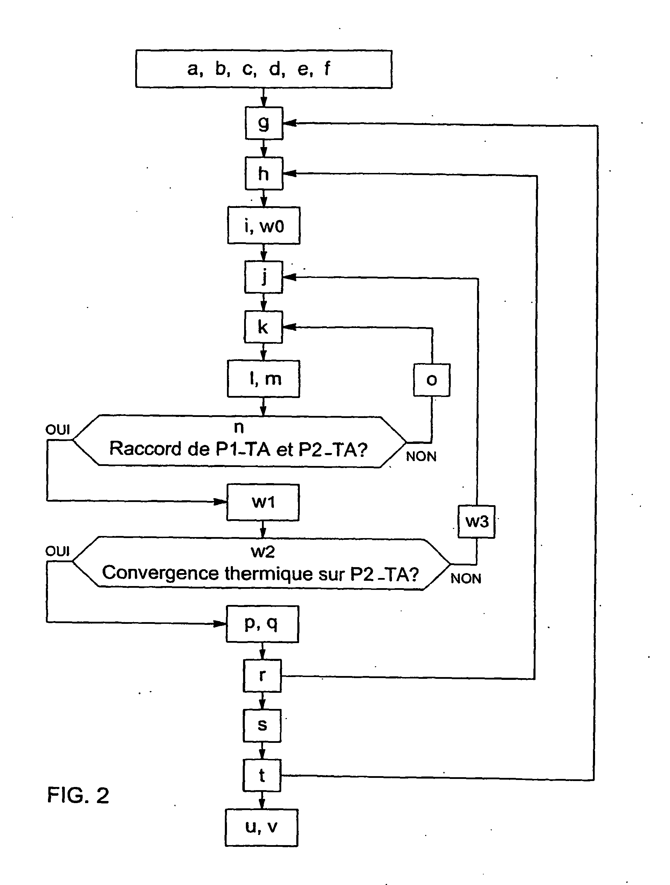

Un tel procédé comprend typiquement les étapes suivantes (figure 2).

(a) L'étape (a) consiste à recenser l'ensemble des paramètres physiques ayant une influence, notamment dans le sens d'une réduction, sur la vitesse que peut adopter le véhicule sur la trajectoire. Cet ensemble de paramètres comprend des paramètres liés aux différents pneus possibles, au châssis du véhicule et/ou aux conditions de roulement, et inclut des paramètres constants et des paramètres dynamiques. En particulier, le sous-ensemble des paramètres constants liés aux conditions de roulement comprend une image numérique de la trajectoire, constituée par des coordonnées numérisées de points successifs de cette trajectoire, tels que les points P11 ou P23 visibles sur la figure 3.

(b) L'étape (b) consiste à développer un modèle de pneu décrivant le comportement physique de chaque pneu en fonction des paramètres physiques pertinents, et notamment en fonction de la température. Un contenu possible de l'étape (b) est décrit en détail dans la section intitulée "Modélisation et simulation des pneumatiques".

(c) L'étape (c) consiste à développer un modèle de véhicule équipé de pneumatiques. Un contenu possible de l'étape (c) est décrit en détail dans la section intitulée "Modélisation et simulation du véhicule".

(d) L'étape (d) consiste à découper l'image numérique de la trajectoire en tronçons adjacents tels que TR1, TR2, etc. (figures 1 et 3), ces tronçons se succédant dans le sens de parcours SU de la trajectoire du véhicule. Chaque tronçon comprend plusieurs points de trajectoire régulièrement espacés les uns des autres, par exemple avec un pas de 5 mètres. Chaque tronçon, supposé orienté dans le sens de parcours SU, commence en un point initial, tel que P11 pour TR1 et P21 pour TR2, et se termine par un point terminal tel que P17 pour TR1 et P25 pour TR2, le point terminal et le point initial de deux tronçons adjacents, par exemple P17 et P21 des tronçons TR1 et TR2, étant confondus. Chaque tronçon est choisi de manière à présenter au plus une sortie de virage et une entrée d'un autre virage. Le point terminal de chaque tronçon est ainsi localisé dans une entrée de virage, et par exemple choisi, par défaut, au point de courbure maximal ou à mi-parcours du virage.

(e) L'étape (e) consiste à associer respectivement au point initial et au point terminal de chaque tronçon des valeurs limites de la vitesse du véhicule, telles que VL11 et VL12. La vitesse limite VL12 au point terminal P17 d'un tronçon TR1 et la vitesse limite VL12 au point initial P21 du tronçon suivant TR2 sont évidemment fixées à la même valeur dans la mesure où ces points sont confondus. Ces valeurs limites sont par exemple choisies ou estimées sur la base de vitesses concrètement mesurées en compétition.

(f) L'étape (f) consiste à sélectionner, en tant que configuration active, une première configuration de pneus destinée à être testée.

(g) L'étape (g) consiste à sélectionner, en tant que tronçon actif, un premier tronçon de trajectoire pour commencer la simulation, par exemple le tronçon TR1 (figures 1 et 3).

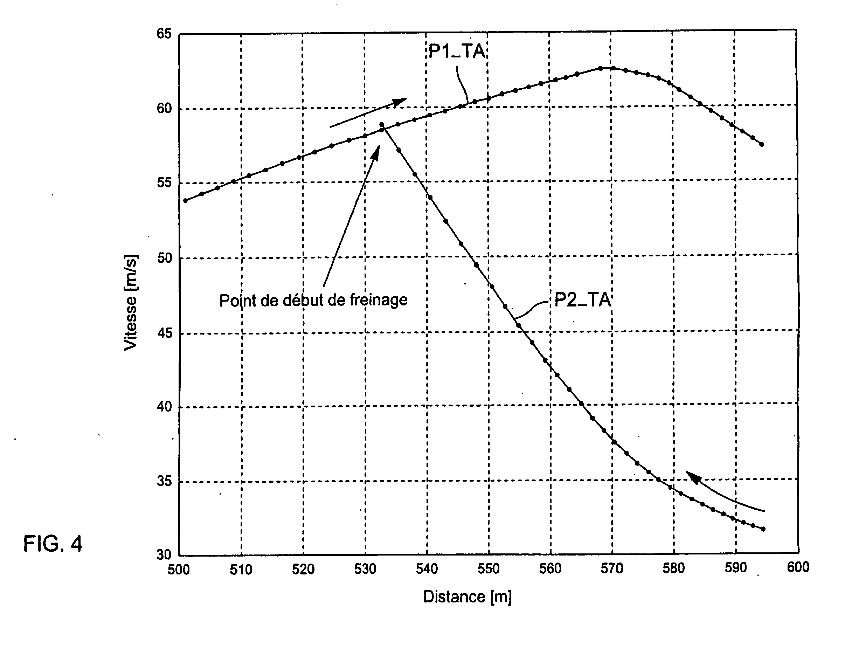

(h) L'étape (h) consiste à simuler, au moyen du modèle de véhicule développé à l'étape (c), le parcours du tronçon actif TR1 ou d'une première partie au moins P1_TA de ce tronçon actif (figure 4), depuis son point initial P11, par le véhicule équipé de la configuration active de pneus. En fait, cette simulation est réalisée en optimisant les sollicitations des pneus de manière que le véhicule accélère au maximum à partir de la vitesse limite V11 associée au point initial P11 de ce tronçon actif, en l'occurrence du tronçon TR1. Dans la mesure où elle fait intervenir des relations non linéaires, cette optimisation doit être réalisée au moyen d'un outil approprié, tel que l'algorithme SQP de programmation quadratique séquentielle, qui est par exemple disponible dans les outils du progiciel vendu sous la dénomination "Matlab 7". Bien que la simulation réalisée à l'étape (h) puisse être effectuée sur toute la longueur du tronçon actif, en l'occurrence TR1, elle n'a pas besoin de l'être, ce qui justifie l'indication du fait que cette simulation est réalisée "sur une première partie au moins P1_TA du tronçon actif". En effet, la simulation réalisée à l'étape (h) est conçue pour simuler le déplacement du véhicule en pleine accélération. Or, dans la mesure où chaque tronçon - à l'exception éventuelle du dernier - se termine par un virage, le véhicule est contraint d'abandonner son régime d'accélération maximale avant la fin de chaque tronçon.

(i) L'étape (i), qui est mise en oeuvre au fur et à mesure du déroulement de l'étape (h), consiste à mémoriser les vitesses adoptées par le véhicule aux différents points, tels que P11, P12, P13, etc. de la première partie P1_TA du tronçon actif, en l'occurrence TR1, et les temps de parcours du véhicule entre ces différents points. Le résultat obtenu à cette étape est équivalent à celui qu'illustre le diagramme de la figure 4, qui représente la vitesse du véhicule au passage des différents points du tronçon, les temps de parcours étant définis par les rapports de la distance par la vitesse.

(w0) L'étape (w0) consiste à sélectionner, en tant que conditions thermiques actives, des conditions thermiques prédéterminées. Cette étape, qui sert à préparer une boucle d'itération permettant le calcul par approximations successives des conditions de freinage du véhicule à la fin du tronçon actif, peut être mise en oeuvre en utilisant par défaut les températures de pneus préalablement mesurées ou estimées sur des véhicules réels aux différents points du tronçon actif.

(j) L'étape (j) consiste à sélectionner, en tant que section active du tronçon actif, la portion de trajectoire définie entre l'avant-dernier point et le point terminal du tronçon actif, c'est-à-dire la section entre les points P16 et P17 lorsque le tronçon actif est TR1 (figure 3).

(k) L'étape (k) consiste à sélectionner, en tant que vitesse cible, la vitesse limite associée au deuxième point de la section active, c'est-à-dire la vitesse VL12 au point P17 lorsque la section active est celle qui s'étend entre P16 et P17.

(l) L'étape (1) consiste à simuler, au moyen du modèle de véhicule, le parcours de la section active (en l'occurrence de P16 à P17) du tronçon actif (en l'occurrence TR1) par le véhicule équipé de la configuration active de pneus. Cette simulation est réalisée en appliquant aux pneus les conditions thermiques actives et en optimisant les sollicitations des pneus et la vitesse V16 du véhicule au premier point P16 de la section active pour atteindre le deuxième point P17 de la section active à la vitesse cible VL12, tout en minimisant le temps de parcours sur cette section active. De même que l'étape (h), l'étape (1) fait donc intervenir des outils d'optimisation avancés quoique bien connus de l'homme du métier et commercialement disponibles. En revanche, contrairement à l'étape (h), l'étape (1) est destinée à décrire le déplacement du véhicule en phase de décélération.

(m) l'étape (m) consiste à effectuer des stockages de données dans une mémoire informatique, et notamment à mémoriser le temps de parcours de la section active (en l'occurrence P16 à P17) par le véhicule, à mémoriser, en tant que vitesse limite, la vitesse V16 du véhicule au premier point P16 de la section active, à mémoriser, en tant qu'élément d'une deuxième partie P2_TA du tronçon actif (en l'occurrence TR1), la section active P16 à P17 qui vient d'être parcourue, et à mémoriser les sollicitations des pneus sur cette section active. La référence ici faite à une "deuxième partie P2_TA" du tronçon actif est justifiée par le souci de distinguer cette deuxième partie, sur laquelle le véhicule est simulé en décélération, de la première partie P1_TA sur laquelle le véhicule a été simulé en accélération. Par ailleurs, comme le montre la figure 4 de façon symbolique par des flèches, la première partie P1_TA est simulée en progressant depuis le point initial du tronçon actif, alors que la deuxième partie P2_TA est simulée en progressant à rebours depuis le point terminal du tronçon actif.

(n) L'étape (n) consiste à vérifier si la vitesse limite V16 du véhicule au premier point P16 de la section active dépasse ou non la vitesse, mémorisée à l'étape (i), qui est adoptée en ce même point P16 par le véhicule lors du parcours de la première partie P1_TA du tronçon actif. De façon plus intuitive, cette étape consiste à tester si la deuxième partie P2_TA, telle qu'elle a été parcourue jusqu'à présent, est ou non suffisante pour se raccorder à la première partie P1_TA dont les caractéristiques ont été mémorisées à l'étape (i).

(o) L'étape (o), qui est seulement mise en oeuvre en cas de réponse négative au test de l'étape (n), consiste d'abord à sélectionner, en tant que nouvelle section active du tronçon actif, la portion de trajectoire définie entre deux points consécutifs du tronçon actif et située immédiatement en amont de la section active chronologiquement précédente, c'est-à-dire en l'occurrence la section s'étendant de P15 à P16, puis à répéter les étapes (k) à (n) en les appliquant à la nouvelle section active P15 à P16.

(w1) L'étape (w1), qui est seulement mise en oeuvre en cas de réponse affirmative au test de l'étape (n), consiste à simuler, au moyen du modèle de véhicule, le parcours par ce véhicule équipé de la configuration active de pneus, section active après section active dans le sens de parcours SU, de la deuxième partie P2_TA du tronçon actif, en appliquant aux pneus sur chaque section active les sollicitations mémorisées à l'étape (m) pour cette section active, et en déduire de nouvelles conditions thermiques d'utilisation des pneus sur cette deuxième partie P2_TA du tronçon actif. De façon plus intuitive, l'étape (w1) consiste donc à parcourir dans le sens réel SU la partie P2_TA du tronçon actif sur laquelle le véhicule est en décélération, en rejouant les sollicitations préalablement mémorisées des pneus pour en déduire des conditions thermiques de fonctionnement des pneus plus adaptées au cas particulier que les conditions thermiques choisies par défaut à l'étape (w0) et précédemment utilisées à l'étape (1) en tant que conditions thermiques actives initiales.

(w2) L'étape (w2) consiste à vérifier si l'écart entre les nouvelles conditions thermiques obtenues à l'étape (w1) et les conditions thermiques actives s'inscrit ou non dans une limite de convergence. En d'autres termes, l'étape (w2) teste si les nouvelles conditions thermiques obtenues sont acceptables, ou s'il est nécessaire de les affiner encore davantage.

(w3) L'étape (w3), qui est seulement mise en oeuvre si les nouvelles conditions thermiques ne sont pas encore acceptables, consiste à mémoriser, en tant que conditions thermiques actives, les nouvelles conditions thermiques obtenues à l'étape (w1) et à répéter les étapes (j) à (w2);

(p) L'étape (p), qui est seulement mise en oeuvre si les nouvelles conditions thermiques ont suffisamment convergé et sont donc acceptables, consiste à mémoriser, en tant que temps de parcours total du tronçon actif (en l'occurrence toujours TR1), la somme du temps de parcours total sur la deuxième partie P2_TA de ce tronçon actif et des temps de parcours mémorisés sur la fraction de la première partie P1_TA de ce tronçon qui ne recouvre pas la deuxième partie, c'est-à-dire sur la fraction de P1_TA située à gauche du point de rencontre de P2_TA et P1_TA sur la figure 4.
(q) L'étape (q) consiste à sélectionner, en tant que nouveau tronçon actif, le tronçon de trajectoire, en l'occurrence TR2, qui succède au tronçon précédemment actif TR1 dans le sens de parcours SU.
(r) L'étape (r) consiste à répéter les étapes (h) à (q) jusqu'à parcourir au moins une fois la trajectoire et à obtenir un temps de parcours cumulé et stabilisé de la trajectoire par le véhicule.
(s) L'étape (s) consiste à sélectionner, en tant que nouvelle configuration active, une deuxième configuration de pneus.
(t) L'étape (t) consiste à répéter les étapes (g) à (r) en utilisant la nouvelle configuration de pneus.
(u) L'étape (u) consiste à comparer les temps de parcours cumulés et stabilisés de la trajectoire, respectivement obtenus avec les première et deuxième configurations de pneus.
(v) Et l'étape (u) consiste à sélectionner, en tant que configuration optimisée, la configuration de pneus conduisant au temps de parcours cumulé et stabilisé de la trajectoire le plus court, le temps de parcours obtenu avec chaque configuration de pneus servant ainsi de temps de référence pour le temps de parcours obtenu avec l'autre configuration de pneus.

Comme indiqué précédemment, la position du point terminal de chaque tronçon peut être choisie à l'étape (d) de façon conventionnelle, ce point étant par exemple fixé au maximum de courbure du virage final de ce tronçon.
Néanmoins, cette position conventionnelle est rarement optimale, les pilotes ayant tendance à remettre le véhicule en accélération en virage avant le point de courbure maximal.
Pour optimiser la simulation du véhicule, le procédé de l'invention peut comprendre une opération supplémentaire, qui est mise en oeuvre à chaque nouveau parcours de la trajectoire, et qui consiste à déplacer le point terminal de chaque tronçon vers l'amont, en direction d'une zone de moindre glissement des pneus.

MODELISATION ET SIMULATION DES PNEUMATIQUES

La présente section décrit un mode possible de réalisation de l'étape (b) et de chaque étape du procédé de l'invention qui implique la simulation du comportement physique de chaque pneu équipant le véhicule en situation de roulement sur le sol.
Dans une situation de roulement d'un pneu au sol, la bande de roulement du pneu présente avec le sol une aire de contact formée d'au moins une zone de contact adhérent et d'au moins une zone de contact glissant.
La finalité de l'étape (b) est de développer les outils permettant de fournir, en fonction d'un certain nombre de grandeurs d'influence, les valeurs de divers efforts qui sont transmis par chaque pneu entre le sol et le véhicule.
La présente section de description fera usage des conventions d'écriture ci-après, qui seront spécifiques à la modélisation des pneumatiques, et dont une partie est déjà communément utilisée dans des modèles de pneu existants connus de l'homme du métier.

| δ | Angle de dérive |
|---|---|
| δ' | Angle de dérive au niveau des nappes sommet |
| $\alpha_1$ | Angle de mise à plat (plysteer) |
| γ | Angle d'inclinaison (carrossage) |
| τ | Taux de glissement longitudinal |
| Fx | Effort longitudinal |
| Fy | Effort transversal |
| Fz | Charge de la roue |
| $V$ | Vitesse des points du sol |
| $W_x$ | Vitesse des points du sommet suivant son axe |
| Mz | Couple d'auto-alignement |
| Ny | Composante du couple d'auto-alignement liée à l'effort Fy |
| Nx | Composante du couple d'auto-alignement liée à la distribution des efforts Fx dans la largeur de l'aire de contact |
| $R_L$ | Rigidité latérale du pneu |
| $R_{LL}$ | Rigidité longitudinale du pneu |
| $K_T$ | Rigidité de torsion du pneu |
| $S_2$ | Souplesse à la flexion sur chant du bloc sommet |
| μ | Coefficient d'adhérence dynamique entre la gomme du pneu et le sol : $\mu(p, Vg, Ts)$ |
| $\mu_0$ | Coefficient d'adhérence statique |
| $Lx$ | Longueur caractéristique de l'aire de contact |
| $Ly$ | Largeur de l'aire de contact |
| $ent$ | Taux d'entaillement de la bande de roulement |
| $AssX$ | Coefficient d'assouplissement longitudinal de la bande de roulement |
| $AssY$ | Coefficient d'assouplissement latéral de la bande de roulement |
| $G^*$ | Module de cisaillement du mélange caoutchouc de la bande de roulement du pneu |
| $e_{KM}$ | Epaisseur de la bande de roulement |
| $a$ | Demi-longueur de l'aire de contact |
| $b$ | Abscisse de début de glissement dans l'aire de contact |
| Ti | Profil de température interne de la gomme, entre la surface du pneu et les nappes sommet |
| Ts | Température de surface moyenne de la bande de roulement |
| Tc | Température de contact à l'interface entre la gomme et le sol |
| Vg | Vitesse de glissement entre le pneu et le sol |
| $X_N, Y_N Y_N$ | Coordonnées des points du sommet du pneu (zone interne de la bande de roulement, à la base du pneu, à la verticale de l'aire de contact) |
| $X_k, Y_k$ | Coordonnées des points de la bande de roulement au niveau de l'interface avec le sol |

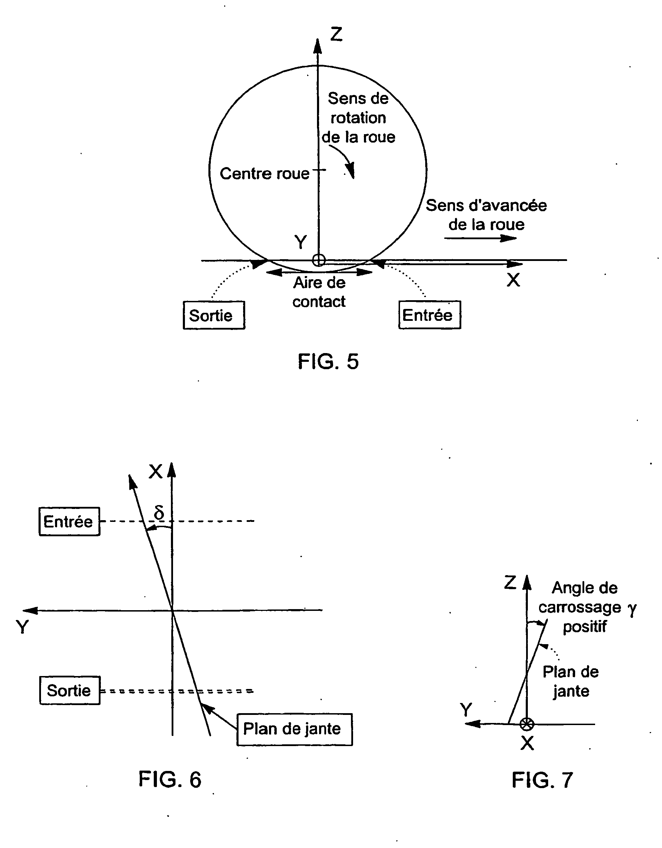

Les figures 5 à 7 précisent le repère utilisé comme référence.
Ce repère est défini par :

O : le point origine du repère au centre de l'aire de contact;

OX: l'axe parallèle au vecteur vitesse;

OY : l'axe perpendiculaire à OX, parallèle au plan du sol quel que soit le carrossage;

Dans ce repère, la convention de signe impose que : pour $\tau > 0$, un effort longitudinal est généré dans la direction de l'axe OX; pour $\delta > 0$, un effort latéral est généré dans la direction de l'axe OY, et pour $\gamma > 0$, un couple dit d'auto-alignement Mz négatif est généré, provoquant une poussée latérale négative (c'est-à-dire orientée dans la direction opposée à OY).

Les efforts transmis par le pneu entre le sol et le véhicule comprennent des efforts longitudinaux *Fx*, des efforts transversaux *Fy*, et un couple d'auto-alignement *Mz*, qui est lié à l'intensité des efforts longitudinaux et transversaux et à leur distribution dans l'aire de contact.

Les grandeurs d'influence comprennent typiquement d'une part des paramètres dynamiques, c'est-à-dire variables au moins en fonction du temps, et liés aux conditions physiques de roulement et d'utilisation du pneu, et d'autre part des paramètres physiques qui sont des paramètres spécifiques au pneu considéré et de valeur constante dans des conditions de référence déterminées.

Les paramètres dynamiques comprennent l'angle de dérive, le taux de glissement, l'angle de carrossage, la charge, la vitesse, la pression de gonflage, les températures air et sol, les températures initiales du pneumatique, et le temps.

Les paramètres spécifiques comprennent les dimensions de l'aire de contact (longueur, largeur, coefficient de forme), le profil de pression p(x) le long de l'aire de contact, les rigidités longitudinale Kx et transversale Ky de la bande de roulement, les rigidités de la structure du pneu, à savoir la rigidité latérale RL, la rigidité longitudinale RLL, la rigidité radiale Rrr, et la rigidité de torsion $k_T$, la rigidité 1/S2 du bloc sommet, une loi d'adhérence $\mu$ du couple gomme/sol, des paramètres de transfert de longueur entre reliefs du pneu ("ribs"), et sont reliées aux paramètres dynamiques par des relations construites par expérimentation spécifique dont il est possible de rendre compte par les expressions données ci-après à titre d'exemple.

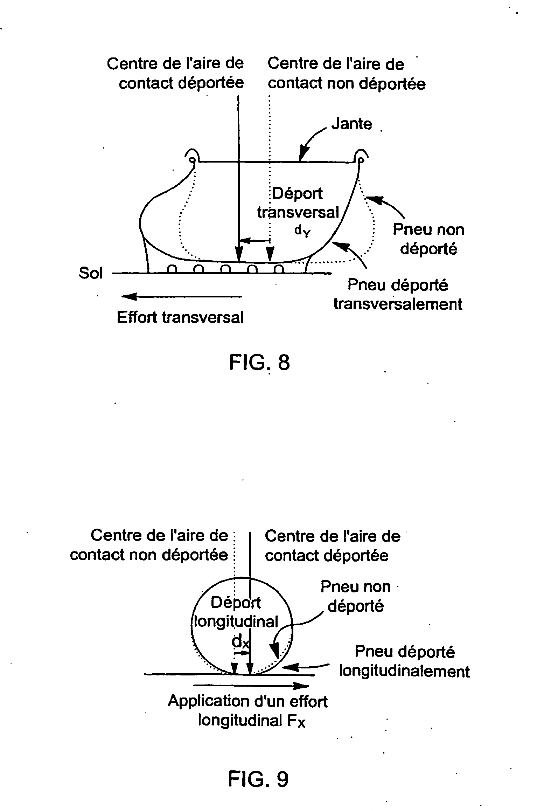

La rigidité latérale correspond à un déport *dy* de l'aire de contact (cf. figure 8) par rapport au plan de roue sous l'effet d'un effort latéral :

$$R_L = R_{L0} + R_{Lp}\, p$$

où $R_{L0}$ [N/m] représente la partie structurelle et $R_{Lp}$ [N/m/bars] la partie pneumatique, *p* étant la pression exprimée en bars.

La rigidité longitudinale correspond à un déport dx de l'aire de contact (cf. figure 9) suivant l'axe longitudinal de la roue en présence d'un effort longitudinal *Fx* :

$$R_{LL} = R_{LL0} + R_{LLp}\, p$$

où $R_{LL0}$ [N/m] représente la partie structurelle et $R_{LLp}$ [N/m/bar] la partie pneumatique, *p* étant la pression exprimée en bars.

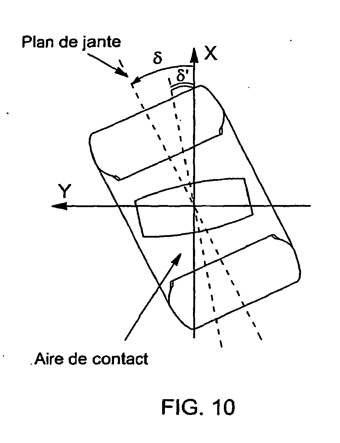

Le développement du couple d'auto-alignement Mz entraîne une torsion d'un angle $\Delta\delta$ de l'enveloppe autour de l'axe Z par rapport au plan de jante (cf. figure 10):

$$\Delta\delta = \frac{M_Z}{k_T}$$

La rigidité de torsion de l'enveloppe contient une composante structurelle $k_{T0}$ [N.m/rad] et une composante $k_{TZ}$ [m/rad] qui traduit la variation de la rigidité de torsion avec la charge par exemple de la forme :

$$k_T = \left(k_{T0} + k_{TZ} F_z\right)\sqrt{p}$$

L'angle de dérive réel δ' pris par l'aire de contact s'exprime en fonction de l'angle de dérive au niveau de l'axe de la roue de la manière suivante :

$$\delta' = \delta + \frac{M_z}{k_T}$$

La déformation du sommet peut être modélisée par une loi du second degré avec une courbure au centre de l'aire de contact qui s'exprime par exemple de la manière suivante :

$$\rho = S_2 F y$$

où $S_2$ est un paramètre représentatif de la souplesse à la flexion sur chant.

La rigidité radiale relie la charge Fz à la flèche du sommet par rapport à la jante. Elle dépend de la pression et se décompose en deux termes : un terme structurel $R_{R0}$ [N/m] qui correspond à la rigidité radiale du pneumatique à pression nulle, et un terme pneumatique $R_{RP}$ [N/m/bar] :

$$R_R = R_{R0} + R_{Rp} p$$

La longueur de l'aire de contact est définie par :

$$Lx = a\sqrt{\frac{F_z}{p^c}} + b\frac{F_z}{p^c},$$

cette formulation permettant de prendre en compte l'effet de la charge et de la pression de gonflage.

La largeur de l'aire de contact est définie par :

$$Ly = Ly_c + 2 * Ly_e$$

où $Ly_c$ est la largeur des reliefs au centre du pneu et $Ly_e$ la largeur des reliefs aux épaules, calculée par la formule ci-dessus :

$$Ly_e = c \arctan\left[d\left(\frac{F_z}{p^{0.6}} - e\right)^2\right].$$

La surface effective de l'aire de contact est définie comme le produit de la largeur par -la longueur, pondéré par l'entaillement et un coefficient de forme :

$$S_{ADC} = C_{forme} \, ent \, Lx \, Ly$$

Le coefficient de forme $C_{forme}$ prend en compte la variation de forme de l'aire de contact en fonction de la charge.

Lors de l'écrasement de la structure du pneu, le sommet prend une inclinaison $\alpha_1$ qui est une grandeur caractéristique de la structure étudiée.

Le profil de pression entre l'entrée et la sortie de l'aire de contact est déterminé de la manière suivante :

$$p(x) = \frac{2n+1}{2n} \frac{F_Z}{S_{ADC}} \left( 1 - \left( \frac{x}{Lx/2} \right)^{2n} \right),$$

Cette répartition de pression est telle que :

$$\int_{-Lx/2}^{Lx/2} p(x)\,dx = \frac{F_Z}{S_{ADC}} \ .$$

A faible charge, le profil est plutôt de type parabolique ($n$ = 1). A forte charge, le profil de pression est quasi uniforme.

De préférence, $n$ est un réel variant linéairement avec la longueur de l'aire de contact $Lx$. Pour éviter qu'aux faibles charges $n$ ne devienne trop faible (voire négatif), $n$ est borné inférieurement à 1 de la façon suivante :

$$n = \max(1, n_a Lx + n_b) \ .$$

Le modèle de pneu mis en oeuvre dans l'invention utilise de préférence au moins un modèle mécanique (premier modèle) couplé à un modèle thermique local (deuxième modèle) et à un modèle thermique global (troisième modèle).

Chacun de ces modèles est établi au cours d'une phase préliminaire de la modélisation du pneu et prend la forme d'un système d'équations.

Ces modèles peuvent être établis de plusieurs manières, et notamment en utilisant des lois physiques connues de l'homme du métier, ou des lois plus ou moins approchées construites par expérimentation spécifique, de sorte que les équations par lesquelles s'expriment ces modèles peuvent prendre de multiples formes.

Ces modèles se caractérisent donc essentiellement par leurs grandeurs d'entrée, leurs grandeurs de sortie, et le fait qu'ils prennent chacun la forme d'un système d'équations rendant compte de phénomènes physiques observables en fonction de propriétés physiques quantifiables.

Les grandeurs de sortie du modèle mécanique de pneu sont les efforts longitudinaux Fx, les efforts latéraux Fy, et le couple d'auto-alignement Mz.

La grandeur de sortie du modèle thermique local est la température de la bande de roulement le long de l'aire de contact.

Et les grandeurs de sortie du modèle thermique global du pneu sont la température moyenne périphérique ou de surface Ts de la bande de roulement, et le profil de la température interne Ti de cette bande dans le sens de son épaisseur.

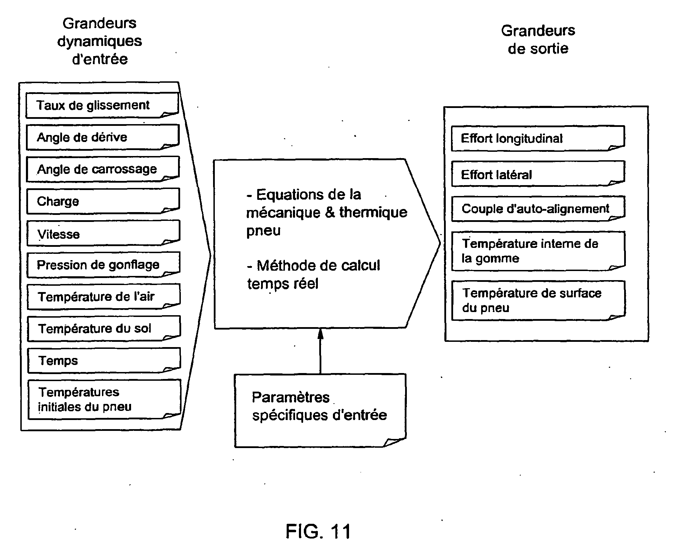

Les grandeurs d'entrée et de sortie de l'ensemble de ces modèles sont recensées sur la figure 11.

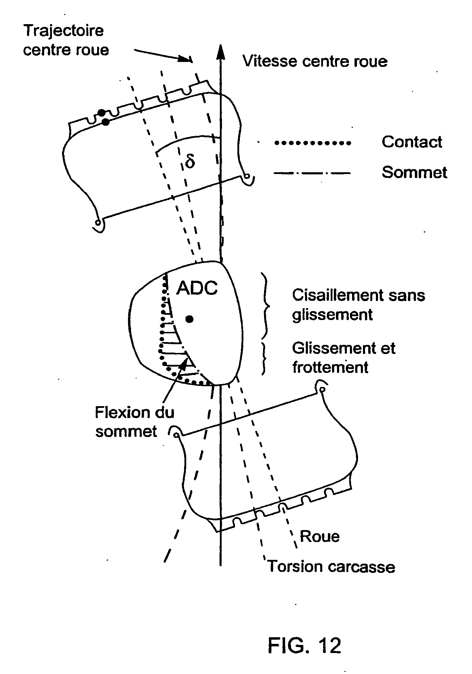

Le modèle mécanique de pneu préféré se caractérise en outre par le fait qu'il est établi en considérant d'une part que l'aire de contact comprend deux zones (figure 12), à savoir une zone de contact adhérent où l'effort est contrôlé par le cisaillement de la bande de roulement à déplacement imposé et une zone de contact glissant où l'effort est contrôlé par le coefficient de frottement entre la gomme et le sol, et en considérant d'autre part qu'il existe un point unique N d'abscisse "b" marquant le passage entre la zone de contact adhérent et la zone de contact glissant.

Les équations sont formulées selon ce principe, ce qui permet d'obtenir des expressions rapides à résoudre.

Un exemple de modèle mécanique avantageux est donné ci-après.

Dans cet exemple, la modélisation du fonctionnement de l'aire de contact est basée sur une approche de type « poil de brosse » avec une première phase de cisaillement en entrée de l'aire de contact et une seconde phase de glissement. Il est supposé que ces deux phases sont distinctes, uniques et connexes, et qu'il n'y a aucun mécanisme parasite de reprise de cisaillement lors de la phase de glissement.

Tous les développements qui suivent font l'hypothèse que les angles de dérive restent modérés (inférieurs à 20 degrés environ), de sorte que l'approximation tan($\delta$)≈$\delta$ est valide et sera faite systématiquement.

$Kx$ et $Ky$ désignent les rigidités de la bande de roulement du pneu, qui peuvent être reliés au module de la gomme et aux caractéristiques de la sculpture de préférence selon la relation suivante :

$$\begin{cases} K_X = \dfrac{G * ent}{\dfrac{h_{scre}}{AssX} + h_{sc}} \\ K_Y = \dfrac{G * ent}{\dfrac{h_{scre}}{AssY} + h_{sc}} \end{cases}$$

$h_{scre}$ étant l'épaisseur de la sculpture, et $h_{sc}$ l'épaisseur de la sous-couche, telles que $e_{KM} = h_{scre} + h_{sc}$.

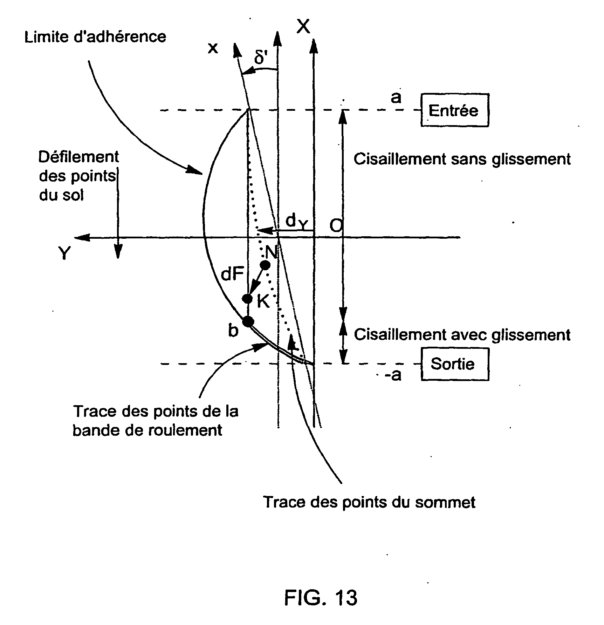

La figure 13 est un schéma fonctionnel de l'aire de contact. Le segment NK définit un élément de la bande de roulement ("poil de brosse"). N est le point situé au niveau du sommet et K est le point de la bande de roulement au niveau du sol. Le point d'abscisse b représente la transition entre le contact avec adhérence et le contact glissant.

En entrée de l'aire de contact (voir figure 13), l'élément de gomme de la bande de roulement du pneu n'est pas cisaillé ($X_N = X_K$).

Le cisaillement de la gomme a en fait plusieurs origines : une mise en dérive de la roue d'un angle $\delta$, une mise en carrossage d'un angle $\gamma$, et une différence entre la vitesse du point N du sommet et la vitesse de défilement des points du sol.

Sous l'hypothèse d'une déformation uniforme dans l'épaisseur de la bande de roulement, l'effort élémentaire généré par le cisaillement d'un l'élément de cette bande peut s'écrire :

$$dF_X = K_X(X_K - X_N)dS$$

$$dF_Y = K_Y(Y_K - Y_N)dS$$

où $dS$ est la surface élémentaire de l'élément NK de la bande de roulement.

L'équation de la trajectoire des points du sommet est approximée par la relation suivante :

$$Y_N = \delta' X_N - \frac{1}{2}S_2 F_Y X_N^2 + \frac{F_Y}{R_L} \, ,$$

expression dans laquelle $\delta'$ est l'angle de dérive du sommet, qui diffère de l'angle de dérive du fait de la torsion de la structure du pneu, et qui répond à l'équation :

$$\delta' = \delta + \alpha 1 + \frac{M_Z}{k_T} \cdot$$

En supposant que la relation $Y_K(\alpha) = Y_N(\alpha)$ soit satisfaite en entrée de l'aire de contact, il vient (équation 1) :

$$Y_K - Y_N = \delta'(a - X_N) - \frac{1}{2}S_2 F_Y\left(a^2 - X_N^2\right)$$

En posant :

$V$ la vitesse des points du sol,

$W_X$ la vitesse des points du sommet suivant son axe, et $\tau = \dfrac{W_X - V}{V}$,

$$\tau = \frac{W_X - V}{V},$$

l'expression $X_K - X_N$ devient (équation 2) :

$$X_K - X_N = (a - X_N)\frac{\tau}{1 + \tau}$$

Par définition, $\tau$ correspond au taux de glissement longitudinal.
Les composantes de la vitesse de glissement sont données par :

$$\begin{cases} Vg_X = \dfrac{d(X_K - X_N)}{dt} = W_X - V \\ Vg_Y = \dfrac{d(Y_K - Y_N)}{dt} = (\delta' - S_2 F_Y X_N)W_X \end{cases}$$

Dans la partie glissante de l'aire de contact, les efforts élémentaires sont générés par le frottement entre la gomme et le sol et la direction des efforts est colinéaire au vecteur cisaillement, ce qui se traduit par :

$$\frac{dF_X}{dF_Y} = r_K \frac{(X_K - X_N)}{(Y_K - Y_N)} \quad \text{avec} \quad r_K = \frac{K_X}{K_{Y'}} \cdot$$

En notant $\beta = \delta' - \dfrac{1}{2} S_2 F_Y (a + X_N)$, il vient :

$$\frac{dF_X}{dF_Y} = r_K \frac{\tau}{(1+\tau)\beta} \ .$$

Les efforts élémentaires dans la zone de frottement s'écrivent :

$$dF_X = \frac{r_K \tau}{\sqrt{(r_K \tau)^2 + (1+\tau)^2 \beta^2}} \mu(p, Vg, T) p \, dS$$

$$dF_Y = \frac{(1+\tau)\beta}{\sqrt{(r_K \tau)^2 + (1+\tau)^2 \beta^2}} \mu(p, Vg, T) p \, dS$$

L'abscisse $b$ du point N à partir duquel est supposé se produire le glissement du pneu sur le sol correspond à l'équilibre entre les efforts élémentaires de cisaillement et d'adhérence, cet équilibre étant représenté par l'équation 3 :

$$[K_X (X_K - X_N)]^2 + [K_Y (Y_K - Y_N)]^2 = [\mu_0 p]^2$$

où $\mu_0$ est le coefficient d'adhérence statique exprimé au point d'abscisse $b$.

Bien qu'il puisse a priori exister dans l'aire de contact plusieurs points de transition entre une zone d'adhérence et une zone glissante, le modèle mécanique de pneu utilisé dans le mode de réalisation préféré de l'invention fait avantageusement l'hypothèse de l'unicité de ce point de transition. En d'autres termes, dès qu'apparaît un glissement dans l'aire de contact, ce glissement est supposé perdurer jusqu'à la sortie de cette aire de contact.

Les équations représentatives du bilan des efforts sous réserve de cette hypothèse d'unicité du point de passage sont données ci-après.

Il est toutefois possible d'en donner une version plus générale, correspondant au cas où plusieurs points de passage existeraient dans l'aire de contact.

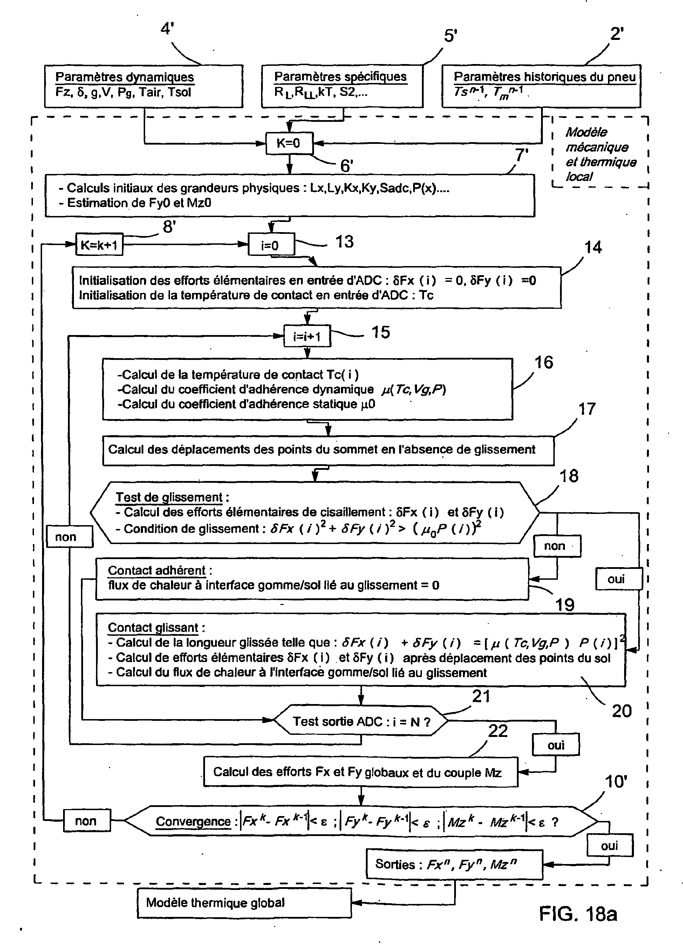

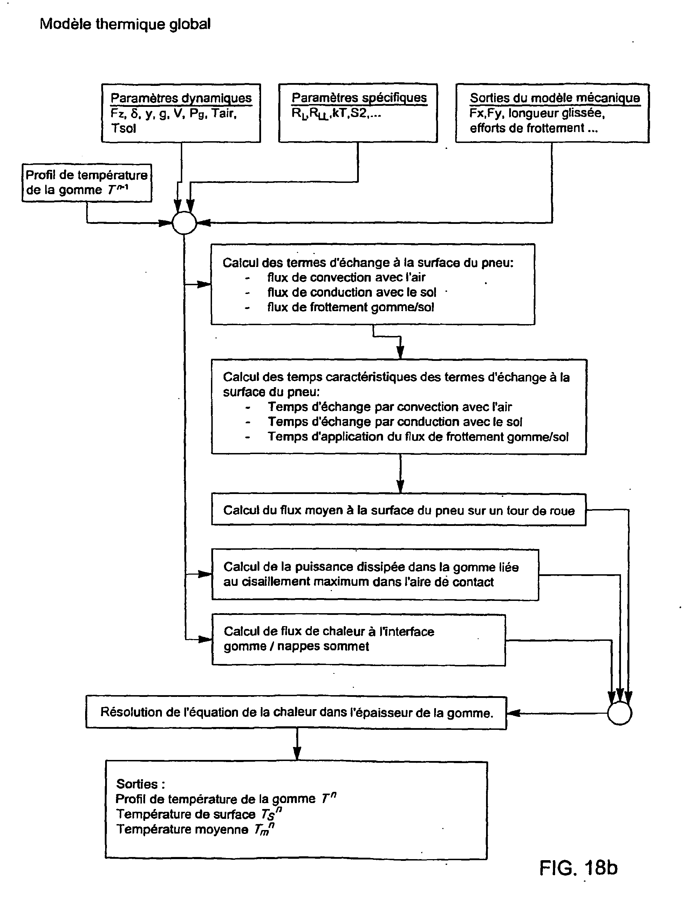

En outre, le mode de réalisation illustré aux figures 18a et 18b, qui utilise une discrétisation de la bande de roulement dans l'aire de contact et qui sera discuté ultérieurement, ne fait aucune hypothèse a priori sur le nombre de points de passage dans l'aire de contact.

Les efforts appliqués au centre de la roue équipée du pneu considéré sont obtenus en intégrant les efforts élémentaires se développant à la surface de l'aire de contact :

$$F_X = \int_{-Ly/2}^{Ly/2} \int_{b}^{a} K_X (X_K - X_N) \, dS + \int_{-Ly/2}^{Ly/2} \int_{-a}^{b} \frac{r_K \tau}{\sqrt{(r_K \tau)^2 + (1+\tau)^2 \beta^2}} \mu(p, Vg, T) p \, dS$$

$$F_Y = \int_{-Ly/2}^{Ly/2} \int_{b}^{a} K_Y (Y_K - Y_N)\, dS + \int_{-Ly/2}^{Ly/2} \int_{-a}^{b} \frac{(1+\tau)\beta}{\sqrt{(r_K\tau)^2 + (1+\tau)^2 \beta^2}} \mu(p,Vg,T) p\, dS$$

L'intégration conduit respectivement aux équations 4 et 5 suivantes :

$$F_X = K_X Ly \left[ \frac{1}{2} \frac{\tau}{1+\tau} (a-b)^2 \right] + Ly\, ent \int_{-a}^{b} \frac{r_K\tau}{\sqrt{(r_K\tau)^2 + (1+\tau)^2 \beta^2}} \mu(p,Vg,T) p\, dx$$

$$F_Y = K_Y Ly \left[ \frac{1}{2} \delta'(a-b)^2 - \frac{S_2 F_Y}{6} (2a^3 - 3a^2 b + b^3) \right] + Ly\, ent \int_{-a}^{b} \frac{(1+\tau)\beta}{\sqrt{(r_K\tau)^2 + (1+\tau)^2 \beta^2}} \mu(p,Vg,T) p$$

Le couple d'auto-alignement $M_Z$ a deux contributions, à savoir un moment $N_Y$ lié à l'effort $F_Y$ dont le centre de poussée est décalé par rapport au centre de l'aire de contact, et un couple $N_X$ lié à la distribution des efforts $F_X$ dans la largeur de l'aire de contact. En général, le couple $N_X$ est un couple de rappel, sauf dans des cas particuliers de fort couple moteur.
Dans le même cadre d'hypothèses que précédemment, le moment $N_Y$ peut être calculé directement par l'équation 6:

$$N_Y = K_Y Ly \left[ \frac{1}{6} \delta'(a^3 - 3ab^2 + 2b^3) - \frac{S_2 F_Y}{8} (a^2 - b^2)^2 \right] + Ly\, ent \int_{-a}^{b} \frac{(1+\tau)\beta}{\sqrt{(r_K\tau)^2 + (1+\tau)^2 \beta^2}} \mu(p,Vg,T) px\, dx$$

Le couple $N_X$ est engendré par une distribution non uniforme des efforts $F_X$ dans la largeur de l'aire de contact, qui tend à s'amplifier lors de la mise en trapèze de l'aire de contact sous l'effet du déport ou du carrossage. Dans une approche de modélisation à une seule bande de relief du pneu, la distribution des efforts $F_X$ dans la largeur de l'aire de contact n'est pas directement accessible. Ainsi, le couple Nx est modélisé par une relation ad hoc dont une formulation mathématique est donnée ci-après à titre indicatif en fonction du moment $N_Y$ et du carrossage (équation 7) :

$$Nx = \beta_1(Fz)Ny + \beta_2(Fz,\delta)\gamma$$

Un exemple de modèles thermiques local et global est donné ci-après.
Le modèle thermique local prend essentiellement en compte les phénomènes thermiques liés au contact de la bande de roulement du pneu avec le sol dans l'aire de contact et au glissement relatif de la bande de roulement dans une partie de l'aire de contact.
Le modèle thermique global prend en compte l'ensemble des phénomènes d'échauffement et des échanges thermiques du pneu sur au moins un tour de roue.
La formulation des efforts globaux du pneumatique est basée sur une décomposition en effort de cisaillement de la bande de roulement et en effort de frottement. L'effort de frottement est fonction du coefficient d'adhérence μ entre la gomme et le sol, ce coefficient dépendant de la pression, de la vitesse de glissement et de la température de contact.
La température de contact dans l'aire de contact est modélisée de la façon suivante (modèle thermique local).
Lors du passage de la gomme dans l'aire de contact, la température de contact évolue en fonction de la conduction thermique et du frottement entre la gomme et le sol. La température dans le contact peut être calculée de différentes manières connues de l'homme de l'art, par exemple à l'aide de méthodes de discrétisation par différences finies.

Le procédé décrit ci-après optimise le temps de calcul tout en conduisant à une précision largement suffisante.

En faisant l'hypothèse de deux matériaux semi-infinis avec une température homogène ($Ts$ pour la gomme et $Tsol$ pour le sol), la température de surface, lorsque les deux massifs sont brusquement mis en contact parfait, s'écrit :

$$T_0 = \frac{T_S e_g + T_{sol} e_{sol}}{e_g + e_{sol}} \, ,$$

où $e_g$ et $e_{sol}$ sont respectivement l'effusivité de la gomme et du sol.

Lorsqu'il y a glissement entre la gomme et le sol, le flux de frottement $\varphi_F$ génère une élévation de température de surface, qui lorsque le flux est constant, s'exprime par :

$$Tc(t) = T_0 + 2\frac{\alpha}{e_g} \varphi_F \sqrt{\frac{t}{\pi}} \, ,$$

où $\alpha$ est le coefficient de partage qui détermine la proportion de flux qui pénètre dans la gomme. Dans le cas d'un contact parfait, ce coefficient s'exprime par :

$$\alpha = \frac{e_g}{e_g + e_{sol}} \, .$$

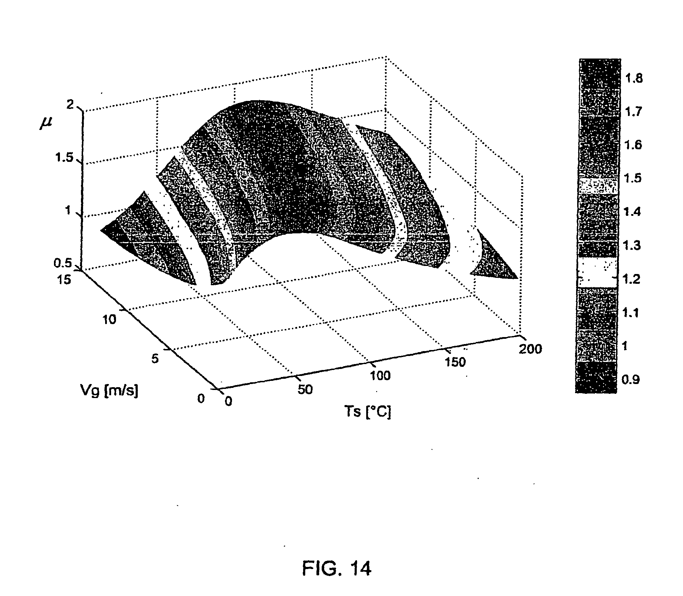

Pour la loi d'adhérence gomme sol, dont la figure 14 illustre la dépendance vis-à-vis des paramètres $Vg$, et $Tc$, plusieurs formulations mathématiques évidentes pour l'homme de l'art permettent de reproduire l'évolution avec la température, vitesse et pression à partir d'expérimentations spécifiques.

A titre d'exemple, on peut utiliser la formule :

$$\mu(T_C, Vg, P_c) = \left(e_1 . P_c^{e_2} + e_3\right) \left[ \mu_1 + \left(\mu_2 - \mu_1\right) \exp\left(- a^2 \log^2\left(\frac{Tc}{T_1}\right)\right) \right]$$

avec $T_1 = T_0 + \alpha_2 \log_{10}(Vg/V_0)/[\alpha_1 - \log_{10}(Vg/Vo)]$, où $\mu_1, \mu_2\, T_0, a, a_1, a_2\, e_1, e_2, e_3, V_0$ sont des constantes du modèle Comme le montre la figure 14, le coefficient d'adhérence $\mu$ a une évolution complexe avec la température et la vitesse de glissement : aux faibles températures, ce coefficient augmente avec la température; aux fortes températures, c'est l'inverse. Le coefficient $\mu$ passe donc par un maximum avec la température. Ce maximum est différent selon la valeur de la vitesse de glissement. Plus la vitesse de glissement est élevée, plus le maximum de ce coefficient est obtenu à des températures élevées.

Le modèle thermique global calcule le profil de température dans l'épaisseur de la gomme en moyenne par tour de roue et dans la largeur de la bande de roulement. Ce modèle permet d'obtenir la température $Ti$ de l'intérieur de la bande de roulement, qui détermine la rigidité $G^*(Ti)$, ainsi que la température de surface (ou périphérique) $Ts$ de la bande de roulement en entrée d'aire de contact, qui est utilisée pour le calcul thermique dans l'aire de contact (modèle local).

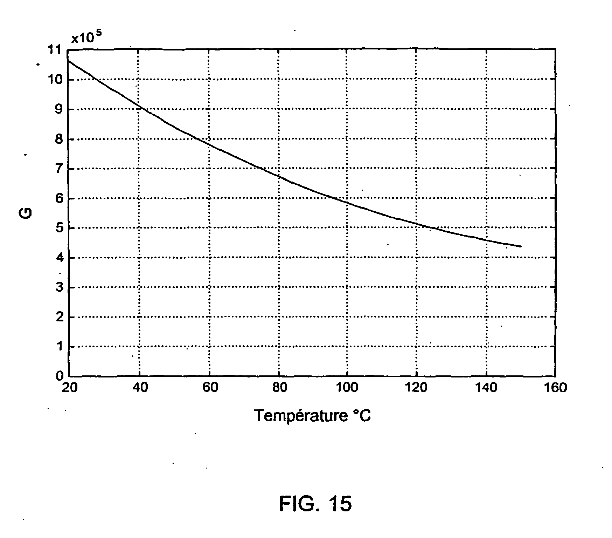

Un exemple de loi liant la rigidité à la température est illustré à la figure 15. En fait, cette loi est propre à chaque matériau utilisé et dépend de la formulation des mélanges constitutifs de la gomme du pneu. D'une manière générale, lorsque la température du mélange augmente, sa rigidité diminue.

Le modèle thermique global prend en compte les mécanismes suivants :

- la conduction dans la gomme;
- l'échauffement par le frottement entre la gomme et le sol;
- l'échauffement lié aux pertes dans la gomme; et
- le refroidissement par conduction avec le sol et convection avec l'air.

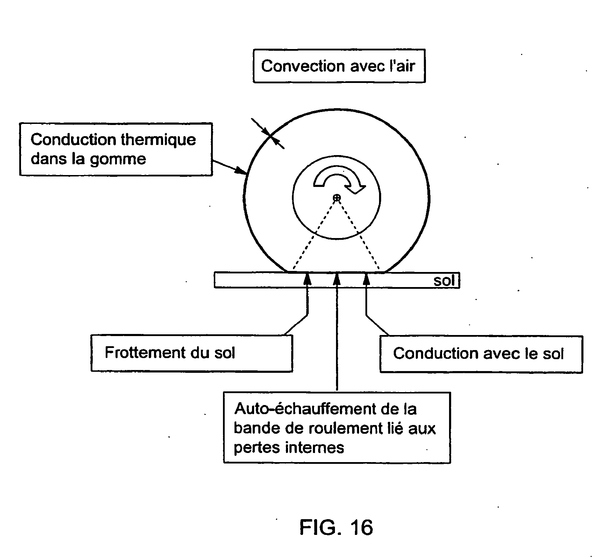

La figure 16 rappelle de façon schématique l'ensemble de ces mécanismes.

En faisant l'hypothèse d'une homogénéité de température dans la largeur de la bande de roulement et sur un tour de roue, il est possible d'obtenir l'équation unidimensionnelle de la chaleur dans le système de coordonnées polaires liée à la roue :

$$\frac{\partial T}{\partial t} = \frac{\lambda}{\rho c_p} \frac{\partial^2 T}{\partial x^2} + \frac{\dot{q}}{\rho c_p},$$

où

$T$ représente le profil de température dans l'épaisseur de la bande de roulement [°K];
$\lambda$ est la conductivité thermique de la gomme [W/m/°K];
$\rho$ est la masse volumique [kg/m$^3$] ;
$c_p$ est la chaleur massique de la gomme [J/kg/°K];
$\dot{q}$ est le terme de production de chaleur due aux pertes dans la gomme en [W/m$^3$];
$x$ représente la direction radiale (i.e. dans l'épaisseur de la bande de roulement);

$$\text{Effusivité : } e = \sqrt{\lambda \rho c_p}$$

$$\text{Diffusivité : } a = \frac{\lambda}{\rho c_p} = \frac{\lambda^2}{e^2} \quad [\text{m}^2/\text{s}]$$

Les conditions aux limites sont cependant différentes selon qu'on considère la surface extérieure du pneu ou l'interface entre la bande de roulement et les nappes du sommet du pneu.

Dans le premier cas, la surface du pneu voit ses conditions aux limites changer sur'un tour de roue : hors de l'aire de contact, il existe un flux de surface due à la convection avec l'air environnant; dans l'aire de contact, il y a un flux de surface lié à la conduction avec le sol et au frottement entre la gomme et le sol. A l'interface gomme/(sol+air), la condition aux limites de flux imposé à la surface du pneu peut s'écrire d'une manière formelle comme suit :

$$-\lambda \frac{\partial T}{\partial x} = \varphi \quad [\text{W/m}^2]$$

où $\varphi$ est un flux de surface qui reste à expliciter.

Les échanges par rayonnement thermique peuvent être négligés.

En revanche, au niveau de l'interface entre la bande de roulement et les nappes du sommet du pneu, l'hypothèse d'un flux nul peut être faite (condition adiabatique).

Le calcul du terme $\dot{q}$ [W/m3] de production de chaleur due aux pertes dans la gomme peut être réalisé de la façon suivante.

Lorsque la gomme passe dans l'aire de contact, elle subit des déformations par compression et cisaillement qui sont source de chaleur. La puissance interne dissipée dans la gomme sur un tour de roue est calculée comme le produit, par la fonction pertes P, de l'énergie fournie lors du passage dans l'aire de contact Wf et de la fréquence de tour de roue :

$$\dot{q} = P W_f f$$

La densité d'énergie de déformation élastique subie par la gomme dans l'aire de contact est explicitée en fonction des efforts longitudinaux, transversaux et de la charge du pneu, ce qui permet d'obtenir la formulation finale :

$$\dot{q} = P(W_f, T) \frac{1}{2G^\bullet} \frac{V}{2\pi R_0} \frac{F_X{}^2 + F_Y{}^2 + F_Z{}^2 / 3}{S_{ADC}{}^2}$$

où $P(W_f, T)$ est la fonction pertes, qui prend en compte le point de fonctionnement de la gomme en température et en amplitude de sollicitation et qui peut être caractérisée par expérimentation spécifique.

La température T correspond à la température caractéristique du mélange et détermine entre autres le niveau de pertes et de module. Sachant que les lois pertes et module sont par exemple mesurées à une fréquence de 10Hz, la température T est en fait une température équivalente au sens de la loi WLF, afin d'avoir une estimation des pertes et module pour des fréquences de sollicitation différentes :

$$T = T_i + C_2 \log_{10}(f/10)/[C_1 - \log_{10}(f/10)],$$

où $T_i$ est la température interne du mélange issue du calcul thermique global, et où $f = V/(2\pi R_0)$ est la fréquence de rotation.

Comme le comprendra aisément l'homme du métier à la lecture de la présente description, la même relation est utilisée pour rélier le module de cisaillement de la gomme à la température interne Ti, ceci afin de prendre en compte les mécanismes de rigidification du mélange lorsque la fréquence du tour de roue augmente.

Pour le calcul du flux de conduction avec le sol, la bande de roulement et le sol peuvent être assimilés à deux murs semi-infinis mis en contact pendant l'intervalle de temps $t_{adc}$. En supposant le contact parfait, le flux de conduction s'écrit :

$$\varphi_{cond} = -2 \frac{e_g e_{sol}}{e_g + e_{sol}} \frac{1}{\sqrt{t_{adc}\pi}} (Ts - T_{sol})$$

où Ts est la température de surface de la gomme.

Le calcul du flux de convection avec l'air est rendu plus difficile par le fait que l'échange thermique avec l'air dépend fortement de la nature de l'écoulement d'air autour du pneu. D'une manière générale, la modélisation des échanges convectifs est basée sur des formulations semi-empiriques. Dans le cas particulier du pneumatique, la formule suivante peut être utilisée :

$$\varphi_{conv} = C_{air} 4.126 (2R_0)^{-0.2} V^{0.805} (Ts - T_{air})$$

où $C_{air}$ est une constante qui prend en compte l'effet de la convection forcée.

Le calcul du flux de frottement doit rendre compte du fait que le frottement constitué par le glissement de la gomme sur le sol est source de production de chaleur. En toute rigueur, la dissipation d'énergie se fait dans le massif de gomme sur des épaisseurs inférieures au millimètre. Dans le cas d'un contact sec, l'approximation peut être faite que l'énergie est dissipée en extrême surface et qu'elle est modélisée par un flux de frottement. Le flux de frottement moyen dans la zone de glissement de l'aire de contact s'écrit comme suit :

$$\varphi_{frot} = \alpha \frac{V_g F_\mu}{(1 - ppa) LxLy\, ent}$$

où $\alpha$ est un coefficient de partage de flux entre la gomme et le sol; une valeur $\alpha$=1 signifie que la totalité du flux de frottement est orienté vers la gomme; une valeur $\alpha$=0 signifie que la totalité du flux de frottement est orienté vers le sol; **[0124]** $F_\mu$ est la composante de l'effort induit par le frottement entre la gomme et le sol; $Vg$ est la vitesse de glissement; et ppa est la proportion de points adhérents dans l'aire de contact.

Le flux thermique moyen à la surface de la bande de roulement est défini comme la moyenne des différents flux, pondérée par la durée caractéristique pendant laquelle ces flux sont effectifs lors d'un tour de roue, ce que traduit la relation :

$$\varphi = \frac{\varphi_{frot}(1 - ppa)t_{adc} + \varphi_{cond}t_{adc} + \varphi_{conv}t_{Hadc}}{t_{adc} + t_{Hadc}}$$

où $t_{adc}$ correspond à la durée de passage d'un élément de la bande de roulement dans l'aire de contact; où $t_{Hadc}$ est la durée de passage d'un élément de la bande de roulement hors de l'aire de contact; et où (1-$ppa$)$t_{acd}$ est la durée pendant laquelle un élément de la bande de roulement glisse dans l'aire de contact.

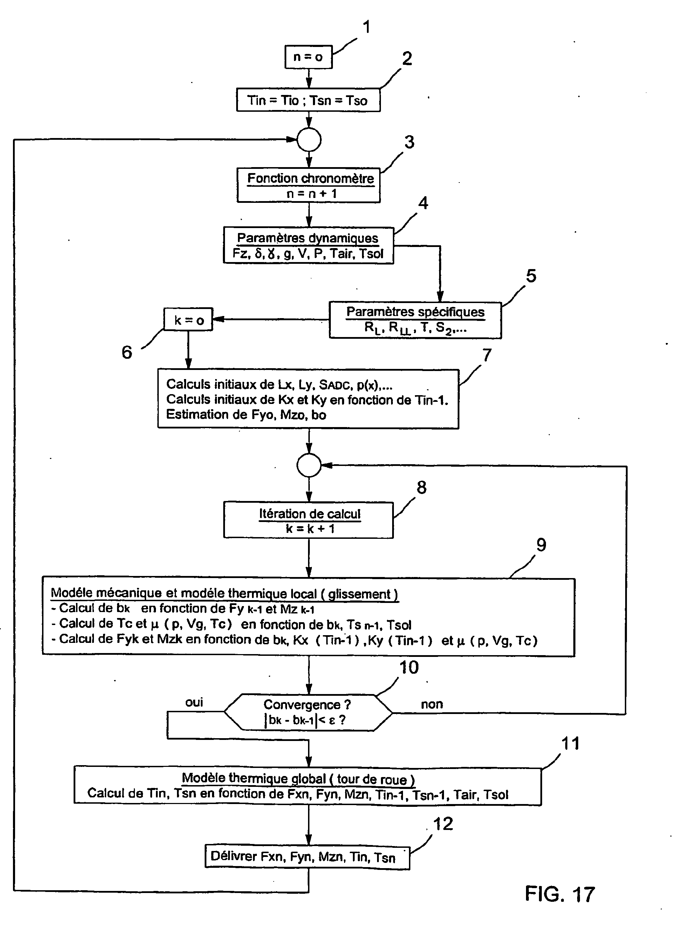

La figure 17 illustre de façon globale la mise en oeuvre opérationnelle d'un procédé conforme au modèle de pneu préféré utilisable dans le procédé de l'invention.

En amont de sa mise en oeuvre opérationnelle, la réalisation de ce modèle de pneu comprend une phase préliminaire de modélisation au cours de laquelle sont établis le modèle mécanique ou premier modèle, le modèle thermique local ou deuxième modèle, et le modèle thermique global tour de roue, ou troisième modèle.

Chaque modèle est établi par application de lois physiques connues et / ou construites par expérimentation spécifique, et prend la forme d'un système d'équations telles que celles présentées ci-dessus pour chaque modèle.

Pour rappel, le modèle mécanique fournit les expressions des efforts longitudinaux et des efforts transversaux qui sont transmis par le pneu entre le sol et le véhicule, du couple d'auto-alignement qui est lié à l'intensité de ces efforts et à leur distribution dans l'aire de contact, et de l'équilibre des forces élémentaires de cisaillement et de glissement du pneu au point N, supposé unique dans le mode de réalisation préféré de l'invention, de passage entre les zones de contact adhérent et glissant, ces expressions étant données en fonction des paramètres dynamiques qui sont liés aux conditions physiques de roulement et d'utilisation du pneu, des paramètres physiques spécifiques du pneu, et de l'abscisse b du point de passage.

Le modèle thermique local fournit l'expression des variations de la température de contact de la bande de roulement avec le sol depuis l'entrée jusqu'à la sortie de l'aire de contact, ces variations dépendant notamment de la température périphérique de la bande de roulement, de la température du sol, et du glissement de la bande de roulement sur le sol.

Le modèle thermique global fournit le profil de température dans l'épaisseur de la bande de roulement et les variations, sur une période de tour de roue, de la température périphérique de la bande de roulement et de la température interne du pneu, en fonction notamment des valeurs antérieurement connues ou estimées des températures périphérique et interne, du coefficient de conduction thermique de la bande de roulement, et de phénomènes à composante thermodynamique tels que les déformations internes subies par le pneu, les échanges thermiques entre le pneu et son environnement, et le glissement de la bande de roulement sur le sol.

Par ailleurs, le modèle mécanique prend en compte le coefficient d'adhérence et le module de cisaillement sous forme de variables respectivement fonctions de la température périphérique et de la température interne.

La phase d'exploitation du modèle de pneu, qui s'appuie sur les résultats de la phase de modélisation, comprend des opérations d'affectation de valeurs numériques et des opérations de résolution.

Les opérations d'affectation consistent essentiellement à attribuer des valeurs numériques aux paramètres dynamiques et aux paramètres spécifiques, tandis que les opérations de résolution consistent essentiellement à déduire, en utilisant notamment le modèle mécanique et les valeurs attribuées aux paramètres dynamiques et aux paramètres physiques spécifiques, les valeurs des efforts longitudinaux Fx, des efforts transversaux Fy, et du couple d'auto-alignement Mz.

La valeur de la température périphérique Ts, qui est obtenue par des opérations de résolution afférentes au modèle thermique global, est utilisée par des opérations de résolution afférentes au modèle thermique local pour prendre en compte la dépendance en température du coefficient d'adhérence.

D'autre part, la valeur de la température interne Ti, qui est également obtenue par des opérations de résolution afférentes au modèle thermique global, est utilisée par des opérations de résolution afférentes au modèle mécanique pour prendre en compte la dépendance en température du module de cisaillement de la gomme du pneu.

Le modèle mécanique inclut de préférence des équations liées aux conditions d'équilibre des forces élémentaires de cisaillement et de glissement de la bande de roulement dans l'aire de contact, et sur la base desquelles s'effectue le couplage entre le modèle mécanique et le modèle thermique local du pneu.

En pratique, la mise en ouvre du modèle de pneu comprend avantageusement une phase itérative de calcul constituée d'une succession de cycles de calcul, chaque cycle de calcul comprenant au moins une opération de résolution afférente au modèle mécanique et une opération de résolution afférente au modèle thermique local.

La phase d'exploitation de ce modèle de pneu, qui fait suite à la phase de modélisation et qui est illustré à la figure 17 pour le mode de réalisation le plus avantageux, comprend d'abord une opération 1 consistant à initialiser un indice compteur n utilisé pour la mesure du temps.

A l'opération 2, des valeurs initiales Tso et Tio sont attribuées à la température périphérique de la bande de roulement et à la température interne du pneu, par exemple en faisant l'hypothèse que le pneu est initialement en équilibre thermique avec l'air ambiant.

L'opération 3 incrémente le temps compté par le chronomètre d'un intervalle de temps correspondant au moins à celui qui est nécessaire pour la réalisation des calculs ultérieurs tels que décrits ci-après.

Des valeurs préalablement mesurées ou mémorisées sont ensuite attribuées aux paramètres dynamiques (opération 4) et aux paramètres spécifiques (opération 5).

L'opération 6 consiste à initialiser un indice compteur k utilisé pour compter le nombre de cycles de calcul successifs effectués à l'intérieur d'une boucle d'itération qui sera décrite ci-après.

L'opération 7 constitue une phase préparatoire destinée notamment à permettre le calcul de grandeurs contingentes dont la valeur peut être considérée comme constante pour les différents cycles de calcul d'une même boucle d'itération, ce qui permet d'éviter l'exécution répétée de ces calculs à chaque cycle de calcul d'une même boucle d'itération.

En particulier; la phase préparatoire 7 est utilisée pour calculer les dimensions Lx et Ly de l'aire de contact, sa surface $S_{ADC}$, le profil de pression p(x) le long de l'aire de contact, de même que les rigidités Kx et Ky de la bande de roulement en fonction de la température interne Ti à l'instant antérieur n-1, c'est-à-dire Tin-1.

Des valeurs estimées Fyo, Mzo et bo sont par ailleurs attribuées aux efforts latéraux Fy, au couple d'auto-alignement Mz, et à l'abscisse b du point N de passage entre la zone de contact adhérent et la zone de contact glissant.

Lorsque les paramètres d'entrée varient peu en fonction du temps, les valeurs estimées Fyo, Mzo et bo peuvent être constituées par les valeurs calculées à l'instant précédent.

Dans le cas contraire, l'abscisse bo de début de glissement est déterminée en supposant que le profil de pression dans la longueur de l'aire de contact est parabolique et en négligeant la rigidité de torsion et la rigidité du sommet.

Dans ce cas, l'équation de glissement (équation 3) a une solution analytique :

$$b_0 = a \left( \frac{4}{3} \frac{a^2}{\mu_0 F_z / Ly} \sqrt{\left[ K_X \frac{\tau}{1+\tau} \right]^2 + \left[ K_Y (\delta + \alpha_1) \right]^2} - 1 \right)$$

Connaissant $b_0$, l'effort $F_{y0}$ et le couple $M_{Z0}$ sont alors calculés à partir des équations 5 à 7.

Il faut en outre vérifier que la position initiale obtenue pour le point de passage satisfait la contrainte sur le signe du cisaillement latéral de la bande de roulement, à savoir $(Y_K - Y_N)\delta' > 0$. Si tel n'est pas le cas, la solution envisagée n'a pas de sens physique. Il faut alors imposer : $Y_K - Y_N = 0$, et la valeur initiale $M_{Z0}$ du couple d'auto-alignement est fixée à 0.

L'opération 8 incrémente l'indice compteur k et permet d'aborder un premier ou un nouveau cycle de calcul (étapes 9 et 10) de la phase itérative.

Cette phase itérative permet de résoudre par approximations successives, et à partir des valeurs antérieurement connues ou estimées de l'abscisse b du point de passage, des efforts transversaux Fy, et du couple d'auto-alignement Mz, de nouvelles valeurs de ces grandeurs b, Fy et Mz qui résolvent les équations 1 à 7 précédemment présentées, pour les valeurs attribuées aux paramètres dynamiques et aux paramètres spécifiques.

Ces équations sont formulées en faisant apparaître l'abscisse b du point de passage entre la zone de contact adhérent et la zone de contact glissant, les efforts dans l'aire de contact étant décomposés en deux contributions, à savoir un effort de cisaillement qui dépend des rigidités de la gomme, du sommet et de la carcasse du pneu, et un effort de frottement qui dépend de la loi de frottement.

L'abscisse b est calculée à partir des équations 1 à 3 et des valeurs de Fy et Mz estimées à l'itération précédente. Il s'agit d'une équation scalaire, dont la solution est bornée (- a ≤ b ≤ a). Le calcul de l'abscisse b est par exemple réalisé par combinaison d'une bissection et d'une sécante.

Si le déplacement proposé par la méthode sécante sort des bornes inférieures et extérieures, le modèle de pneu bascule sur un pas de bissection.

Plusieurs solutions de l'abscisse b étant a priori possibles, la solution retenue est celle qui satisfait la condition

$(Y_K\text{-}Y_N)\delta'>0$. Les intégrales $\displaystyle\int_{-a}^{b}\mu(P(x),T,Vg)P(x)\,dx$ et $\displaystyle\int_{-a}^{b}\mu(P(x),T,Vg)P(x)x\,dx$ liées au frottement sur le sol de la gomme de la bande de roulement sont par exemple calculées en utilisant les formules de quadrature de Gauss.

Pour le calcul des résidus du système constitué par les équations 4, 5, et 6+7, et le calcul de la convergence, il s'agit de résoudre le système non linéaire de n équations en n inconnues noté de manière formelle : $F(x) = 0$.

Bien que plusieurs procédés itératifs soient possibles, le procédé optimal semble être constitué par le procédé itératif mixte de type Newton-Raphson/Broyden connu de l'homme de l'art.

A chaque cycle de calcul d'ordre k, l'étape 9 comprend notamment une opération consistant à calculer une nouvelle valeur provisoire $b_k$ de l'abscisse du point de passage à partir des équations 1 à 3 d'équilibre des forces élémentaires et des valeurs antérieurement connues ou estimées $F_{Yk-1}$ et $M_{Zk-1}$ des efforts transversaux et du couple d'auto-alignement.

Dans le cas du modèle de pneu préféré, dans lequel le modèle mécanique est enrichi par le modèle thermique local et prend notamment en compte l'influence de l'évolution de la température de contact sur la valeur du coefficient de frottement de la gomme du pneu sur le sol, l'étape 9 comprend également, pour chaque point de la zone de contact glissant, le calcul de la température de contact Tc et du coefficient de frottement en fonction de la valeur provisoire nouvellement calculée $b_k$ de l'abscisse du point de passage, de la température périphérique $T_{sn-1}$ telle que connue à l'instant précédent, et de la température du sol $T_{sol}$, la température périphérique $T_{sn-1}$ du pneu étant utilisée pour le calcul de la température de contact en entrée de la surface de contact.

Enfin, l'étape 9 comprend l'opération qui consiste à calculer, à partir de la nouvelle valeur provisoire $b_k$ de l'abscisse du point de passage, des valeurs des rigidités Kx et Ky de la bande de roulement pour la température interne Tin-1 telle qu'elle est connue à l'instant antérieur, de la valeur du coefficient de frottement $\mu$, et des équations 1 à 7, de nouvelles valeurs $F_{Yk}$ et $M_{Zk}$ des efforts transversaux et du couple d'auto-alignement, utilisables pour un éventuel cycle de calcul ultérieur.

L'étape 10 consiste à tester la convergence de la phase itérative.

Par exemple, si les écarts respectifs entre d'une part les nouvelles valeurs $b_k$, $F_{Yk}$ et $M_{Zk}$ et d'autre part les valeurs provisoires $b_{k-1}$, $F_{Yk-1}$ et $MZ_{k-1}$ issues du cycle de calcul précédent sont inférieurs à des limites respectives telles que $\varepsilon$, alors la phase itérative est interrompue. Dans le cas contraire, cette phase itérative est poursuivie par rebouclage en amont de l'opération 8.

A l'interruption de la phase itérative, le modèle thermique global tour de roue est utilisé (étape 11) pour calculer les nouvelles valeurs à jour $T_{sn}$ et $T_{in}$ des températures périphérique et interne en tenant compte des évolutions subies par ces températures, depuis la fin de la phase itérative précédente, sous l'effet de l'ensemble des phénomènes à composante thermodynamique, tels que les déformations internes subies par le pneu, les échanges thermiques entre le pneu et son environnement (air, sol), et le glissement de la bande de roulement sur le sol.

On rappelle que la température Ts est la température de surface moyenne, à la fois dans la largeur et dans la circonférence du pneu, de la bande de roulement, et que le calcul des températures Ti et Ts s'appuie sur une modélisation unidirectionnelle dans l'épaisseur de la bande de roulement.

Les équations du modèle thermique global sont résolues par une approche classique de méthode par différences finies en utilisant un maillage spatial dans l'épaisseur de la gomme et une méthode de résolution dans le temps de type Runge-Kutta d'ordre 2.

L'opération 12, mise en oeuvre à la sortie de la phase itérative, consiste à délivrer, pour l'instant n, les valeurs des efforts longitudinaux et transversaux Fxn, Fyn, du couple d'auto-alignement Mzn, de la température interne Tin du pneu, et de la température périphérique Tsn de la bande de roulement.

Le procédé est alors rebouclé juste en amont de l'opération 3 d'incrémentation du chronomètre, et avant l'opération 4 de mise à jour des paramètres dynamiques qui permet de tenir compte des évolutions subies par ces paramètres pendant le temps d'exécution de la phase itérative qui vient de se terminer.

La nouvelle valeur Tin de la température interne du pneu sera utilisée pour l'opération 5 de mise à jour des paramètres spécifiques, ou au cours de la phase préparatoire 7, pour en déduire la nouvelle valeur de la rigidité G* du mélange constitutif de la gomme du pneu, qui conditionné les valeurs des rigidités Kx et Ky.

Par ailleurs, la nouvelle valeur Tsn de la température périphérique de la bande de roulement sera utilisée lors de l'étape 9 pour le calcul de la température de contact Tc en entrée de la bande de roulement.

On comprend donc que le couplage entre le processus de détermination des efforts et le processus de détermination des températures intervient à deux niveaux, à savoir d'une part par la prise en compte du fait que la température moyenne Ti de la bande de roulement influe sur la rigidité G* du mélange et donc sur les rigidités Kx et Ky de la bande de roulement, et d'autre part par la prise en compte du fait que la température périphérique Ts de la bande de roulement dans l'aire de contact influe sur le coefficient d'adhérence entre la gomme et le sol.

Le procédé de simulation de pneu qui vient d'être décrit est notamment applicable à la simulation en temps réel du comportement dynamique d'un véhicule doté d'un châssis et de plusieurs pneus en situation de roulement sur le sol.

Ce modèle de pneu peut alors par exemple être mis en oeuvre sur un ordinateur portable ayant les caractéristiques suivantes : PC Windows XP, Pentium 4 3.6Ghz, 2Go de mémoire ; les performances du procédé de simulation d'un pneu seul en situation de roulage dérive et en présence de glissement sont de 9000 calculs complets à la seconde, où chaque calcul correspond à la détermination des efforts longitudinaux et transversaux, du couple d'auto-alignement et des températures de surface et interne du pneu à un instant donné en fonction des paramètres dynamiques et spécifiques.

Dans les applications véhicule, chacun des modèles mécanique, thermique local et thermique global, ou au moins le premier d'entre eux, est exploité pour chaque pneu et associé à un modèle dynamique de châssis dont un exemple sera fourni ultérieurement.

Chacun des modèles de pneu coopère avec ce modèle de châssis d'une part pour recevoir du modèle de châssis les valeurs des paramètres dynamiques ou de certains d'entre eux au moins, et d'autre part pour permettre au modèle de châssis d'exploiter, pour chaque pneu, les valeurs des efforts longitudinaux, des efforts transversaux, et du couple d'auto-alignement obtenues par la mise en oeuvre des modèles de pneu.

Les figures 18a et 18b illustrent, pour un intervalle de temps n déterminé, la phase d'exploitation d'un autre modèle de simulation de pneu qui, bien que beaucoup moins économique que le précédent en calculs, offre lui aussi un grand réalisme.

Dans cet autre modèle de pneu, l'aire de contact est discrétiséé par exemple sur N zones successives de sa longueur et l'équilibre des forces élémentaires de cisaillement et de glissement de la bande de roulement dans l'aire de contact (ADC) est examiné sur chaque élément de surface.

Plus précisément, chaque cycle de chaque phase itérative comprend N opérations successives d'analyse des conditions d'équilibre des forces élémentaires de cisaillement et de glissement sur les N surfaces élémentaires respectives différentes de l'aire de contact, et chaque cycle de la phase itérative est interrompu lorsque l'ensemble des surfaces élémentaires considérées lors de ce cycle recouvre l'aire de contact.

Les opérations 2', et 4' à 8' de ce modèle sont respectivement les mêmes que les opérations 2 et 4 à 8 du modèle de la figure 17.

L'opération 13 consiste à initialiser un indice compteur i utilisé pour compter les opérations d'analyse des conditions d'équilibre des forces élémentaires sur les différentes surfaces élémentaires.

L'opération 14 constitue une phase préparatoire destinée à fixer à zéro les valeurs des efforts élémentaires transversaux et longitudinaux $\delta Fx(i)$ et $\delta Fy(i)$ s'exerçant en amont de la première surface élémentaire de l'aire de contact, et à fixer la valeur initiale de la température de contact Tc.

L'opération 15 incrémente l'indice compteur i et permet d'aborder l'analyse des efforts élémentaires dans une première ou une nouvelle surface élémentaire de l'aire de contact, les opérations 16 et 17 étant consacrées au calcul de ces efforts.

Le test 18 vise à déterminer si les efforts élémentaires de cisaillement de la bande de roulement sont ou non supérieurs à l'adhérence.

Dans la négative, l'opération 19 fixe à zéro l'échauffement qui aurait été lié au glissement de la bande de contact sur le sol.

En revanche, en cas de glissement, l'opération 20 détermine avec.précision les conditions de glissement et calcule le flux de chaleur lié à ce glissement conformément au modèle thermique local.

Qu'il y ait ou non glissement, le test 21 est effectué pour déterminer si la surface élémentaire considérée est ou non la dernière des N surfaces élémentaires de la bande de roulement dans l'aire de contact discrétisée.

Dans la négative, la surface suivante est analysée après retour à l'opération 15.

Sinon, l'opération 22 est effectuée pour calculer les efforts longitudinaux et transversaux ainsi que le couple d'auto-alignement par sommation des efforts élémentaires et des couples élémentaires obtenus pour les différentes surfaces élémentaires.

Le test 10', qui est équivalent au test 10 de la figure 17, conduit soit à retourner à l'opération 8' pour poursuivre la phase itérative, soit à fournir les valeurs des efforts et du couple d'auto-alignement pour le cycle de calcul considéré et à mettre en oeuvre les opérations d'affectation et de résolution pour le modèle thermique global, telles que recensées de façon directement lisible sur la figure 18b.


MODELISATION ET SIMULATION DU VEHICULE

La présente section décrit un mode possible de réalisation de l'étape (c) et de chaque étape du procédé de l'invention qui implique la simulation du comportement physique du véhicule en utilisant un modèle de châssis complété par un modèle de pneu, ce dernier étant par exemple constitué par le modèle décrit dans la section précédente.

La présente section de description fera usage des conventions d'écriture supplémentaires ci-après.

| | |
|---|---|
| $Tr$ | Traînée aérodynamique |
| g% | Taux de glissement (Slip Ratio) |
| $\alpha_v$ | Angle volant |
| $P$ | Pression de gonflage d'un pneu (vecteur à quatre composantes) |
| $\Psi$ | Angle de lacet (rotation autour de l'axe vertical du véhicule) |
| $\Psi$ | Vitesse de lacet (rotation autour de l'axe vertical du véhicule) |
| $t$ | Temps |
| $x$ | Position du véhicule (vecteur à deux composantes) |
| $v$ | Vitesse du véhicule (idem) |
| $a$ | Accélération du véhicule (idem) |
| $R$ | Rayon de courbure de la trajectoire |
| $m$ | Masse du véhicule [Kg] |
| $h_{CDG}$ | Hauteur du centre de gravité [m] |
| $H_{CDR}$ | Hauteur du centre de roulis [m] |
| $E$ | Empattement du véhicule [m], avec $E = e_1 + e_2$ |
| $e_1$ | Distance entre le centre de gravité et l'essieu avant [m] |
| $e_2$ | Distance entre le centre de gravité et l'essieu arrière [m] |
| $Voie$ | Voie [m]. A priori, la voie n'est pas la même à l'arrière et à l'avant. Il faut distinguer : |
| | $Voie_{AV}$: $l_1$ [m] |
| | $Voie_{AR}$ : $l_2$ [m] |

Par ailleurs, quand il sera nécessaire de se référer à une grandeur par roue, les notations suivantes seront utilisées :

l'indice 1 désigne la roue avant gauche (par exemple $Fx_1$) ;
l'indice 2 désigne la roue avant droite (par exemple $Fx_2$) ;
l'indice 3 désigne la roue arrière gauche (par exemple $Fx_3$ ) ;
l'indice 4 désigne la roue arrière droite (par exemple $Fx_4$).

En réalité, la simulation d'un véhicule au sens de la présente description inclut implicitement un modèle du pilote en plus d'un modèle de châssis du véhicule et d'un modèle de pneu.

Cependant, le pilote est supposé suivre une trajectoire imposée, de sorte que les commandes appliquées par le modèle de pilote au véhicule sont limitées aux sollicitations appliquées aux pneus, c'est-à-dire aux glissements et aux dérives.

Un véhicule de compétition tel qu'une Formule 1 est simulé par un modèle de châssis et de pneus de type quadricycle, alors qu'une moto est simulée par un modèle de type bicycle.

Cependant, le modèle quadricycle est typiquement obtenu par extension du modèle bicycle, auquel sont rajoutées des relations décrivant le transfert de charge latéral en virage (il y a donc une charge par roue et non plus par essieu) et des relations décrivant le carrossage par roue (inclinaison).

La plupart des données du modèle véhicule peuvent être obtenues directement ou indirectement à partir de mesures effectuées sur des véhicules réels.

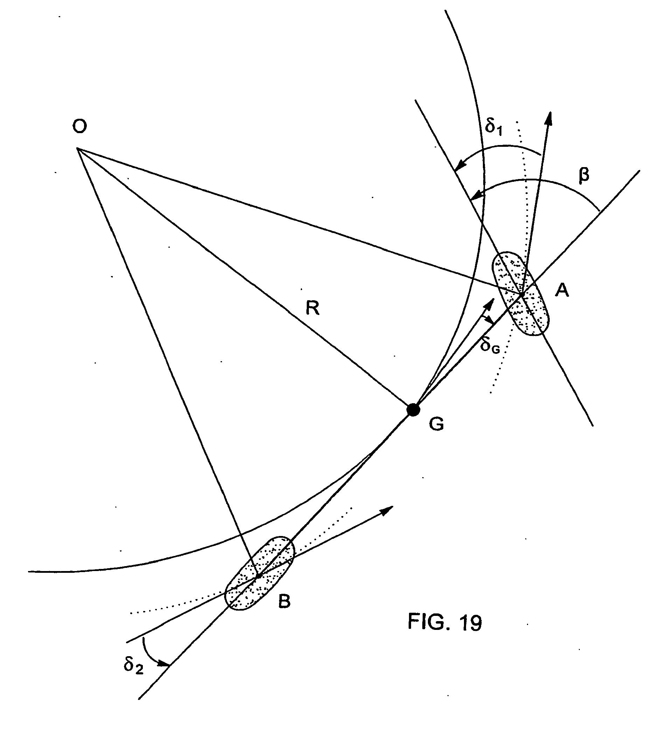

Le fonctionnement en régime permanent d'un véhicule bicycle, bien connu de l'homme du métier, est rapidement rappelé ci-après en référence à la figure 19.

A un instant t, le bicycle suit une trajectoire circulaire de rayon de courbure $R$, avec une vitesse $V$.

Une accélération centrifuge s'exerce sur le centre de gravité du véhicule. Pour prendre le virage, le véhicule va devoir compenser cette accélération avec des efforts générés par les essieux avant et arrière. Ces efforts seront produits par la mise en dérive des pneus avant et arrière.

Les vecteurs vitesses du centre de gravité G et des centres des roues sont représentés par les flèches de direction tangente à la trajectoire circulaire de centre O et de rayon R.

La distance entre le centre de gravité G et l'essieu avant (A) est notée $l_1$ ; la distance entre le centre de gravité G et l'essieu arrière (B) est notée $l_2$ ; la dérive avant est notée $\delta_1$ ; la dérive arrière est notée $\delta_2$ ; la dérive de caisse, angle entre le vecteur vitesse en G et l'orientation du véhicule est notée $\delta_G$ ; l'angle de braquage de l'essieu avant est noté $\beta$.

Dans ces conditions, l'angle de dérive de caisse se calcule par :

$$\delta_G = \delta_2 - \frac{l_2}{R}.$$

Et l'angle de braquage de l'essieu avant est donné par :

$$\beta = \frac{l_1 + l_2}{R} + \delta_1 - \delta_2.$$

Dans le modèle quadricycle, le carrossage par roue peut être modélisé (de façon purement heuristique) par une fonction affine de l'accélération transversale $a_T$ suivant la formule :

$$\gamma = k_{\gamma 1} a_T + k_{\gamma 2},$$

dans laquelle les paramètres $k_{\gamma 1}$ et $k\gamma_2$ peuvent être obtenus à partir de mesures sur des véhicules réels, le signe de l'accélération transversal dépendant de la localisation droite ou gauche de la concavité du virage.

Dans la mesure où la charge aérodynamique (ici notée $Fz$ par dérogation aux notations choisies) qui est appliquée sur la voiture évolue avec la vitesse, elle est prise en compte sous la forme d'un polynôme d'ordre 4 dépendant de cette vitesse, tel que :

$$Fz = kz_0 + kz_1 v + kz_2 v^2 + kz_3 v^3 + kz_4 v^4,$$

ce polynôme étant établi par approximation de relevés expérimentaux.

La charge totale se répartit ensuite sur les essieux avant et arrière suivant la balance aérodynamique $B$ :

$$\begin{cases} Fz = Fz_{AV} + Fz_{AR} \\ \dfrac{Fz_{AV}}{F_z} = B \end{cases}$$

la balance aérodynamique étant supposée être une fonction affine de la vitesse, donc de la forme :

$$B = k_{B0} + k_{B1}v$$

Il est d'usage de s'intéresser aux valeurs de la balance aérodynamique à 150 km/h et 250 km/h.

Si les $Fz_i$ sont les charges par roue mesurées sur les différentes roues du véhicule, et si m la masse (éventuellement corrigée de la consommation de carburant), alors la charge aérodynamique totale est donnée par :

$$\sum_{i=1}^{4} Fz_i - 9.81\,m$$

Il convient également de prendre en compte la traînée, qui est une force aérodynamique longitudinale s'opposant à l'avancée du véhicule, particulièrement importante à haute vitesse. Cette force est en fait retranchée à la somme des efforts $Fx_i$ dans l'équation d'équilibre longitudinal du véhicule.

La traînée est par exemple modélisée par un polynôme d'ordre 2 du type :

$$Tr = k_{Tr0} + k_{Tr1}v + k_{Tr2}v^2 \,.$$

Le moteur du véhicule peut, quant à lui, être simplement modélisé par une puissance maximum disponible environ 850 ch. avec un moteur V10, et 650 ch. avec un moteur V8 et par exemple un unique régime moteur.

En conséquence, la puissance délivrée par l'essieu arrière est limité par la puissance maximum exprimée en chevaux, à savoir :

$$\left(F_{X3} + F_{X4}\right)v \leq 746\,p_{\max} \,.$$

En régime permanent, le véhicule va être régi par les équations de la dynamique reliant les accélérations aux efforts et moments, ces équations concernant :

L'équation d'équilibre longitudinal :

$$ma_L = \sum Fx + Tr \,,$$

l'équation d'équilibre transversal :

$$ma_T = \sum Fy \,,$$

et l'équation d'équilibre de lacet, qui peut être approchée par la formule :

$$\ddot{\psi} = \frac{d}{dt}\left(\frac{v}{R}\right) = \frac{1}{R^2}\left(\frac{dv}{dt}R - v\frac{dR}{dt}\right) = \frac{a_L}{R} \,.$$

La charge verticale par roue est la somme de quatre contributions, à savoir :

- une charge statique correspondant à la masse du véhicule répartie par essieu puis par roue;
- une charge aérodynamique calculée comme indiqué plus haut;
- un transfert de charge longitudinal; et
- un transfert de charge transversal

La charge à l'essieu peut être calculée à l'aide de la répartition de masse (par exemple : $r_{AV}$ = 48% pour l'avant et $r_{AR}$ = 52% pour l'arrière). Ainsi, on pourrait avoir :

$$Fz_{AV} = 9.81\, \dot{m}\, r_{Masse\,AV},$$

$$Fz_{AR} = 9.81\, m\, r_{Masse\,AR},$$

la charge par roue étant la moitié de la charge à l'essieu.

La charge aérodynamique peut être calculée comme indiqué plus haut. La charge aérodynamique par roue est estimée à la moitié de la charge sur l'essieu.

Le transfert de charge longitudinal proportionnel à l'accélération longitudinale du véhicule est donné par :

$$\Delta Fz_L = m\, a_L\, \frac{h_{CDG}}{E}.$$

Cette charge est retranchée à l'essieu avant et ajoutée à l'essieu arrière : en freinage, $\alpha_L < 0$, de sorte qu'une partie de la charge est transférée sur l'essieu avant.

Comme précédemment, cette contribution doit être divisée par deux pour obtenir la valeur par roue.

Le transfert de charge transversal proportionnel à l'accélération transversale du véhicule est donné par :

$$\Delta Fz_T = -m\, a_T\, \frac{h_{CDR}}{Voie}\, r_{Roulis}.$$

La voie étant différente à l'avant et à l'arrière, les transferts de charge transversaux ne seront naturellement pas les mêmes. De plus la répartition de roulis n'est pas la même entre l'essieu avant et l'essieu arrière.

La répartition de roulis est calculée à l'aide de la balance en roulis qui dépend de la vitesse, et donc :

$$\begin{cases} r_{Roulis\,AV} = k_{Roulis1}\, v + k_{Roulis2} \\ r_{Roulis\,AR} = 1 - r_{Roulis\,AV} \end{cases}.$$

Les coefficients de la loi de répartition de roulis peuvent être obtenus par des mesures sur les véhicules réels.

Les transferts de charge latéraux doivent être ajoutés sur les roues gauches et retranchés sur les roues droites, sans division par deux contrairement aux cas précédents.

D'autres équations peuvent en outre être ajoutées au modèle de véhicule sous la forme de contraintes à respecter pour améliorer le réalisme de la simulation.

La simulation du véhicule pris dans son ensemble, c'est-à-dire constitué par le châssis et les pneus, est réalisée, de façon connue en soi, en injectant dans les paramètres d'entrée du modèle de châssis les sollicitations mécaniques transmises par les pneus au châssis, telles qu'elles sont connues par les calculs effectués sur la base du modèle de pneus appliqué à l'ensemble des pneus, et en injectant dans les paramètres d'entrée du modèle de pneu appliqué à chaque pneu les sollicitations mécaniques transmises par le châssis à chaque pneu, telles qu'elles sont connues par les calculs effectués sur la base du modèle de châssis.

**Revendications**

1. Procédé pour sélectionner, parmi un ensemble de configurations possibles, une configuration optimisée de pneumatiques pour équiper un véhicule destiné à courir sur un circuit en suivant une trajectoire prédéterminée, orientée dans un sens unique de parcours et incluant des virages, ce procédé comprenant au moins les étapes mises en oeuvre sur un ordinateur et consistant à :

- développer un modèle physique du véhicule équipé d'une première configuration de pneus;
- découper une image numérique de la trajectoire en tronçons successifs se raccordant en.des points auxquels sont associées des valeurs limites de la vitesse du véhicule ;
- simuler par itérations le parcours, par le véhicule modélisé, de chaque tronçon de trajectoire, d'abord en accélération maximale sur des portions de trajectoire prises successivement dans le sens de parcours réel et appartenant à une première partie de tronçon incluant un point initial de ce tronçon, puis en décélération maximale sur des portions de trajectoire prises successivement en amont les unes des autres et appartenant à une deuxième partie de tronçon incluant un point terminal de ce tronçon, et en raccordant les première et deuxième parties de tronçon en un point du tronçon où la vitesse du véhicule modélisé sur la première partie de ce tronçon ne dépasse pas la vitesse du véhicule modélisé sur la deuxième partie de ce tronçon;
- mémoriser le temps de parcours mis par le véhicule pour parcourir au moins une fois la trajectoire;
- comparer le temps de parcours à au moins un temps de référence et produire un résultat de comparaison; et
- sélectionner ou non la première configuration comme configuration optimisée en fonction du résultat de comparaison.

**2.** Procédé suivant la revendication 1, **caractérisé en ce que** le modèle du véhicule inclut un modèle thermomécanique des pneus équipant ce véhicule.

**3.** Procédé suivant l'une quelconque des revendications précédentes, **caractérisé en ce qu'**il comprend les étapes consistant à :

(a) recenser un ensemble de paramètres physiques tendant à limiter la vitesse adoptée par le véhicule sur la trajectoire, cet ensemble comprenant des paramètres constants et des paramètres dynamiques, ces paramètres étant liés aux différents pneus possibles, au châssis du véhicule et/ou aux conditions de roulement, et incluant une image numérique de la trajectoire, constituée par des coordonnées numérisées de points successifs de cette trajectoire;

(b) développer un modèle de pneu décrivant le comportement physique de chaque pneu et faisant intervenir un premier sous-ensemble de l'ensemble des paramètres physiques;

(c) développer un modèle de véhicule faisant intervenir à la fois le modèle de pneu et un deuxième sous-ensemble de l'ensemble des paramètres physiques, et décrivant le comportement physique du véhicule en fonction au moins de sollicitations des pneus, ces sollicitations comprenant des glissements et des dérives;

(d) découper l'image numérique de la trajectoire en tronçons adjacents se succédant dans le sens de parcours et dont chacun comprend un ensemble d'au moins trois points de trajectoire incluant un point initial et un point terminal de ce tronçon se succédant dans cet ordre dans le sens de parcours, le point terminal étant localisé dans une entrée de virage;

(e) associer respectivement aux points initial et terminal de chaque tronçon des valeurs limites de la vitesse du véhicule;

(f) sélectionner, en tant que configuration active, une première configuration de pneus;

(g) sélectionner, en tant que tronçon actif, un premier tronçon de trajectoire;

(h) simuler, au moyen du modèle de véhicule, le parcours d'une première partie au moins du tronçon actif de trajectoire, depuis son point initial, par le véhicule équipé de la configuration active de pneus, en optimisant les sollicitations des pneus pour maximiser l'accélération subie par le véhicule à partir de la vitesse limite associée au point initial de ce tronçon actif;

(i) mémoriser les vitesses du véhicule aux différents points de la première partie du tronçon actif et les temps de parcours entre ces différents points;

(j) sélectionner, en tant que section active du tronçon actif, la portion de trajectoire définie entre un premier et un deuxième points d'une paire de points du tronçon actif se succédant dans cet ordre dans le sens de parcours, le deuxième point de cette paire étant constitué par le point terminal du tronçon actif;

(k) sélectionner, en tant que vitesse cible, la vitesse limite associée au deuxième point de la section active;

(l) simuler, au moyen du modèle de véhicule, le parcours de la section active du tronçon actif par le véhicule équipé de la configuration active de pneus, en optimisant les sollicitations des pneus et la vitesse adoptée par le véhicule au premier point de la section active pour atteindre le deuxième point de la section active à la vitesse cible, tout en minimisant le temps de parcours sur cette section active;

(m) mémoriser le temps de parcours de la section active par le véhicule; mémoriser, en tant que vitesse limite, la vitesse du véhicule au premier point de la section active; et mémoriser, en tuant qu'élément d'une deuxième partie du tronçon actif, la section active parcourue;

(n) vérifier si la vitesse limite du véhicule au premier point de la section active dépasse ou non la vitesse, mémorisée, à l'étape (i), qui est adoptée en ce même point par le véhicule lors du parcours de la première partie du tronçon actif;

(o) dans la négative, sélectionner, en tant que nouvelle section active du tronçon actif, une portion de trajectoire située en amont, par rapport au sens de parcours, de la section active chronologiquement précédente, et définie entre un premier et un deuxième points d'une paire de points du tronçon actif se succédant dans cet ordre dans le sens de parcours, le deuxième point de cette paire étant constitué par le premier point de la section active chronologiquement précédente, et répéter les étapes (k) à (n);

(p) dans l'affirmative, mémoriser, en tant que temps de parcours total du tronçon actif, la somme du temps de parcours total sur la deuxième partie de ce tronçon actif et des temps de parcours mémorisés sur la fraction de la première partie de ce tronçon qui ne recouvre pas la deuxième partie;

(q) sélectionner, en tant que nouveau tronçon actif, le tronçon de trajectoire qui succède au tronçon précédemment actif dans le sens de parcours;

(r) répéter les étapes (h) à (q) jusqu'à parcourir au moins une fois la trajectoire et obtenir un temps de parcours cumulé et stabilisé de la trajectoire par le véhicule.

4.  Procédé suivant la revendication 3, **caractérisé en ce qu'**il comprend en outre les étapes consistant à :

(s) sélectionner, en tant que nouvelle configuration active, une deuxième configuration de pneus;
(t) répéter les étapes (g) à (r);
(u) comparer les temps de parcours cumulés et stabilisés de la trajectoire, respectivement obtenus avec les première et deuxième configurations de pneus; et
(v) sélectionner, en tant que configuration optimisée, la configuration de pneus conduisant au plus court temps de parcours cumulé et stabilisé de la trajectoire, le temps de parcours obtenu avec chaque configuration de pneus servant ainsi de temps de référence pour le temps de parcours obtenu avec l'autre configuration de pneus.

5.  Procédé suivant l'une quelconque des revendications 3 et 4, **caractérisé en ce que** le modèle de pneu est un modèle thermomécanique, **en ce que** l'étape (j) est précédée d'une étape (w0) consistant à sélectionner, en tant que conditions thermiques actives, des conditions thermiques prédéterminées, **en ce que** l'étape (1) est réalisée en appliquant aux pneus les conditions thermiques actives, **en ce que** l'étape (m) inclut l'opération élémentaire supplémentaire qui consiste à mémoriser les sollicitations des pneus sur chaque section active, et **en ce que** l'étape (p) est immédiatement précédée d'une boucle d'itération comprenant les étapes consistant à :

(w1) en cas de succès de la vérification réalisée à l'étape (n), simuler au moyen du modèle de véhicule le parcours par ce véhicule équipé de la configuration active de pneus, section active après section active dans le sens de parcours, de la deuxième partie du tronçon actif, en appliquant aux pneus sur chaque section active les sollicitations mémorisées à l'étape (m) pour cette section active, et en déduire de nouvelles conditions thermiques d'utilisation des pneus sur la deuxième partie du tronçon actif;

(w2) vérifier si l'écart entre les nouvelles conditions thermiques et les conditions thermiques actives s'inscrit ou non dans une limite de convergence; et

(w3) dans la négative, mémoriser, en tant que conditions thermiques actives, les nouvelles conditions thermiques et répéter les étapes (j) à (w2).

6.  Procédé suivant l'une quelconque des revendications 3 à 5, **caractérisé en ce que** l'étape (d) est mise en oeuvre en fixant le point terminal de chaque tronçon au maximum de courbure d'un virage.

7.  Procédé suivant l'une quelconque des revendications 3 à 6, **caractérisé en ce qu'**il comprend une opération supplémentaire, mise en oeuvre à chaque nouveau parcours de la trajectoire et consistant à déplacer le point terminal de chaque tronçon vers l'amont, en direction d'une zone de moindre glissement des pneus.

8.  procédé suivant l'une quelconque des revendications 3 à 7, **caractérisé en ce que** le modèle de pneu développé à l'étape (b) décrit le comportement physique de chaque pneu équipant le véhicule en situation de roulement sur le sol, avec lequel la bande de roulement du pneu présente une aire de contact incluant au moins une zone de contact adhérent et au moins une zone de contact glissant, **en ce que** l'étape (b) comprend au moins des opérations de modélisation, **en ce que** chaque étape de simulation (h, 1, w1) comprend des opérations d'affectation de valeurs numériques et des opérations de résolution, les opérations de modélisation consistant au moins à établir, par application de lois physiques connues et / ou construites par expérimentation spécifique, et en tant que premier modèle, un modèle des efforts longitudinaux (Fx), des efforts transversaux (Fy), et d'un couple d'auto-alignement (Mz), transmis par le pneu entre le sol et le véhicule, en fonction de paramètres physiques spécifiques, incluant un coefficient d'adhérence et un module de cisaillement de la gomme du pneu, et en fonction de paramètres dynamiques liés aux conditions physiques de roulement et d'utilisation du pneu, le couple d'auto-alignement étant lié à l'intensité des efforts longitudinaux et transversaux et à leur distribution dans l'aire de contact, les opérations d'affectation consistant au moins à attribuer (4) des valeurs numériques aux paramètres dynamiques et aux paramètres spécifiques (5), et les opérations de résolution consistant au moins à déduire, en utilisant au moins le premier modèle et les valeurs attribuées aux paramètres dynamiques et aux paramètres physiques spécifiques, des valeurs des efforts longitudinaux (Fx), des efforts transversaux (Fy), et du couple d'auto-alignement (Mz), **en ce que** les opérations de modélisation comprennent aussi l'établissement, en tant que second modèle, d'un modèle local d'échauffement exprimant des variations d'une température de contact de la bande de roulement avec le sol depuis l'entrée jusqu'à la sortie de l'aire de contact par suite du contact et du glissement de la bande de roulement avec le sol, et l'établissement, en tant que troisième modèle, d'un modèle global d'échauffement et de flux thermique, ce troisième modèle exprimant des variations, sur une période d'au moins un tour de roue, d'une température périphérique de la bande de roulement et d'une température interne du pneu en fonction de valeurs antérieurement connues ou estimées des températures périphérique et interne, d'un coefficient de conduction thermique de la bande de roulement, et de phénomènes à composante thermodynamique tels que déformations internes subies par le pneu, échanges thermiques entre le pneu et son environnement, et glissement de la bande de roulement sur le sol, **en ce qu'**au moins le coefficient d'adhérence et le module de cisaillement interviennent dans le premier modèle comme des variables respectivement fonctions de la température périphérique et de la température interne, **en ce que** la valeur de la température périphérique (Ts), obtenue par des opérations de résolution afférentes au troisième modèle, est utilisée par des opérations de résolution afférentes au deuxième modèle pour prendre en compte la dépendance en température du coefficient d'adhérence, et **en ce que** la valeur de la température interne (Ti), obtenue par des opérations de résolution afférentes au troisième modèle, est utilisée par des opérations de résolution afférentes au premier modèle pour prendre en compte la dépendance en température du module de cisaillement de la gomme du pneu.

9.  Procédé de simulation suivant la revendication 8, **caractérisé en ce que** le premier modèle inclut des équations liées à des conditions d'équilibre des forces élémentaires de cisaillement et de glissement de la bande de roulement dans l'aire de contact, **en ce que** ce procédé comprend au moins une phase itérative de calcul constituée d'une succession de cycles de calcul, et **en ce que** chaque cycle de calcul comprend au moins une opération de résolution afférente au premier modèle et une opération de résolution afférente au deuxième modèle.

10. Procédé de simulation suivant la revendication 9, **caractérisé en ce que** le premier modèle est établi en considérant que l'aire de contact comprend une unique zone de contact adhérent et une unique zone de contact glissant séparées l'une de l'autre par un point de passage, **en ce que** le premier modèle prend la forme d'un système d'équations exprimées au moins en fonction des paramètres dynamiques, des paramètres spécifiques, et de l'abscisse (b) du point de passage, **en ce que** chaque phase itérative est dédiée à des phénomènes apparaissant pendant un intervalle de temps élémentaire correspondant, et **en ce que** chaque phase itérative est mise en oeuvre pour résoudre, par approximations successives et au moins à partir de valeurs antérieurement connues ou estimées de l'abscisse (bo) du point de passage, des efforts transversaux (Fyo), et du couple d'auto-alignement (Mzo), de nouvelles valeurs de l'abscisse (b) du point de passage, des efforts transversaux (Fy), et du couple d'auto-alignement (Mz) qui résolvent le système d'équations du premier modèle pour les valeurs attribuées aux paramètres dynamiques et aux paramètres spécifiques, ce dont il résulte que les efforts longitudinaux, les efforts transversaux, et le couple d'auto-alignement du pneu peuvent être calculés en temps réel pendant le roulement du véhicule.

11. Procédé de simulation suivant la revendication 10, **caractérisé en ce que** chaque nouveau cycle de calcul de chaque phase itérative comprend les opérations (9) consistant au moins à :

     - calculer une nouvelle valeur provisoire de l'abscisse du point de passage à partir des équations d'équilibre des forces élémentaires et des valeurs antérieurement connues ou estimées des efforts transversaux et du couple d'auto-alignement;
     - calculer, à partir de la nouvelle valeur provisoire de l'abscisse du point de passage et des équations liant les efforts transversaux et le couple d'auto-alignement aux paramètres dynamiques, aux paramètres spécifiques, et à l'abscisse du point de passage, de nouvelles valeurs des efforts transversaux et du couple d'auto-alignement utilisables pour un éventuel cycle de calcul ultérieur;
     - interrompre conditionnellement (10) ladite phase itérative au moins lorsque l'écart entre la nouvelle valeur provisoire de l'abscisse du point de passage et la valeur antérieurement connue ou estimée de cette abscisse est inférieur à une limite de précision prédéterminée; et

- à l'interruption de ladite phase itérative, affecter (12) aux efforts longitudinaux et transversaux et au couple d'auto-alignement, en tant que valeurs pour cette phase, les nouvelles valeurs des efforts longitudinaux et transversaux et du couple d'auto-alignement obtenues au dernier cycle de calcul.

12. Procédé de simulation suivant la revendication 10 ou 11, **caractérisé en ce qu'**il comprend en outre une opération de mise en oeuvre après la fin de chaque phase itérative et consistant à mettre au moins à jour (4) les paramètres dynamiques pour tenir compte des évolutions subies par ces paramètres pendant le temps d'exécution de la phase itérative, et à engager une nouvelle phase itérative (8-10).

13. Procédé de simulation suivant l'une quelconque des revendications 8 à 12, **caractérisé en ce que** les opérations de résolution afférentes au troisième modèle sont effectuées en dehors de chaque phase itérative.

14. Procédé suivant l'une quelconque des revendications 8 à 13, **caractérisé en ce que** chacun des premier, deuxième et troisième modèles est exploité pour chaque pneu et associé à un modèle dynamique de châssis, **en ce que** le modèle de châssis fournit auxdits premier, deuxième et troisième modèles, pour chaque pneu, les valeurs de certains au moins des paramètres dynamiques, et **en ce que** le modèle de châssis exploite, pour chaque pneu, les valeurs des efforts longitudinaux, des efforts transversaux, et du couple d'auto-alignement obtenues par la mise en oeuvre desdits premier, deuxième et troisième modèles.

## Claims

1. Method for selecting, from a set of possible configurations, an optimized tire configuration for fitting a vehicle intended to run on a circuit following a predefined route, oriented in a single course direction and including bends, said method comprising at least steps consisting of:

   - developing a physical model of the vehicle fitted with a first tire configuration;
   - dividing a digital image of the route into successive segments by connecting at points with associated vehicle speed limit values;
   - simulating, in iterations, the course by the modeled vehicle, of each route segment, firstly at maximum acceleration on portions of route taken successively in the actual course direction and belonging to a first segment portion including an initial point of said segment, and at maximum deceleration on route portions taken successively upstream from each other and belonging to a second segment portion including an end point of said segment, and connecting the first and second segment portions at a point of the segment where the speed of the modeled vehicle on the first portion of said segment does not exceed the speed of the modeled vehicle on the second portion of said segment;
   - storing in memory the course time taken by the vehicle to cover the route at least once;
   - comparing the course time to at least one reference time and producing a comparison result; and
   - optionally selecting the first configuration at the optimized configuration as a function of the comparison result.

2. Method according to claim 1, **characterized in that** the vehicle model includes a thermomechanical model of the tires fitted in the vehicle.

3. Method according to claim 1, **characterized in that** it comprises steps consisting of:

   (a) inventorying a set of physical parameters tending to limit the speed adopted by the vehicle on the route, said parameters being linked with the different possible tires, vehicle chassis and/or driving conditions, said parameters being linked with the different possible tires, and including a digital image of the route, consisting of digitized coordinates of successive points of said route;
   (b) developing a tire model describing the physical behavior of each tire and involving a first subset of the set of physical parameters;
   (c) developing a vehicle model involving both the tire model and a second subset of the set of physical parameters, and describing the physical behavior of the vehicle as a function at least of tire stresses, said stresses comprising slips and drifts;
   (d) dividing the digital image of the route into adjacent successive segments in the course direction, each comprising a set of at least three route points including an initial point and an end point of said segment in succession in this order in the course direction, the end point being located in an incoming bend;

(e) respectively associating vehicle speed limit values with the initial and end points of each segment;

(f) selecting, as the active configuration, a first tire configuration;

(g) selecting, as the active segment, a first route segment;

(h) simulating, by means of the vehicle model, the course of at least a first portion of the active route segment, from the initial point thereof, by the vehicle fitted with the active tire configuration, by optimizing the tire stresses to maximize the acceleration applied to the vehicle from the limit speed associated with the initial point of said active segment;

(i) storing in memory the vehicle speeds with the various points of the first portion of the active segment and the course times between said different points;

(j) selecting, as the active section of the active segment, the route portion defined between a first and second point of a pair of points of the active segment in succession in this order in the course direction, the second point of said pair consisting of the end point of the active segment;

(k) selecting, as the target speed, the limit speed associated with the second point of the active section;

(l) simulating, by means of the vehicle model, the course of the active section of the active segment by the vehicle fitted with the active tire configuration, by optimizing the tire stresses and the speed adopted by the vehicle at the first point of the active section to reach the second point of the active section at the target speed, while minimizing the course time on said active section;

(m) storing in memory the course time of the active section by the vehicle; storing in memory, as the limit speed, the vehicle speed at the first point of the active section; and storing in memory, as an element of a second portion of the active segment, the active section covered;

(n) verifying whether the vehicle limit speed at the first point of the active section exceeds the speed stored in memory in step (i) or not, which is adopted at the same point by the vehicle during the course of the first portion of the active segment;

(o) if this is not the case, selecting, as a new active section of the active segment, a route portion located upstream, with respect to the course direction, from the chronologically previous active section, and defined between a first and a second point of a pair of points of the active segment in succession in this order in the course direction, the second point of said pair consisting of the first point of the chronologically previous active section, and repeating steps (k) to (n);

(p) if this is the case, storing in memory, as the total course time of the active segment, the sum of the total course time on the second part of said active segment and the course times stored in memory on the fraction of the first portion of said segment not overlapping with the second portion;

(q) selecting, as the new active segment, the route segment following the previously active segment in the course direction;

(r) repeating steps (h) to (q) until the route is covered at least once and a cumulative and stabilized course time by the vehicle is obtained.

4. Method according to claim 3, **characterized in that** it further comprises steps consisting of:

(s) selecting, as the new active configuration, a second tire configuration;

(t) repeating steps (g) to (r);

(u) comparing the cumulative and stabilized route times, respectively obtained with the first and second tire configuration; and

(v) selecting, as the optimized configuration, the tire configuration resulting in the shortest cumulative and stabilized course time of the route, the course time obtained with each tire configuration thus serving as the reference time for the course time obtained with the other tire configuration.

5. Method according to claim 3, **characterized in that** the tire model is a thermomechanical model, **in that** step (j) is preceded by a step (w0) consisting of selecting, as active thermal conditions, predefined thermal conditions, **in that** step (1) is performed by applying the active thermal conditions to the tires, **in that** step (m) includes the further basic operation consisting of storing in memory the tire stresses on each active section, and **in that** step (p) is immediately preceded by an iteration loop comprising steps consisting of:

(w1) in the event of a successful verification performed in step (n), simulating by means of the vehicle model the course by said vehicle fitted with the active tire configuration, active section after active section in the course direction, of the second portion of the active segment, by applying to the tires on each active section the stresses stored in memory in step (m) for said active section, and deducing new thermal conditions of use of the tires on the second portion of the active segment;

(w2) verifying whether the difference between the new thermal conditions and the active thermal conditions is within a convergence limit or not; and

(w3) if this is not the case, storing in memory, as the active thermal conditions, the new thermal conditions and repeating steps (j) to (w2).

6. Method according to claim 3, **characterized in that** step (d) is implemented by setting the end point of each segment to the maximum curvature of a bend.

7. Method according to claim 3, **characterized in that** it comprises a further operation, implemented for each new course of the route and consisting of moving the end point of each segment upstream, in the direction of a zone having less tire slip.

8. Method according to claim 3, **characterized in that** the tire model developed in step (b) describes the physical behavior of each tire fitted on the vehicle when driving on the ground, wherewith the tire tread has a contact area including at least one adherent contact zone and at least one slippery contact zone, **in that** step (b) comprises at least modeling operations, **in that** each simulation step (h, 1, w1) comprises digital value allocation operations and resolution operations, **in that** the modeling operations consist at least of defining, by applying physical laws that are known and / or constructed by specific experimentation, and as the first model, a model of the longitudinal forces (Fx), transversal forces (Fy) and a self-alignment torque (Mz), transmitted by the tire between the ground and the vehicle, as a function of specific physical parameters, including an adherence coefficient and a shear modulus of the tire rubber, and as a function of dynamic parameters associated with the physical driving and usage conditions of the tire, the self-alignment torque being linked with the intensity of the longitudinal and transversal forces and the distribution thereof in the contact area, the allocation operations consisting at least of attributing (4) digital values to the dynamic parameters and the specific parameters (5), and the resolution operations consisting at least of deducing, using at least the first model and the values attributed to the dynamic parameters and the specific physical parameters, the values of the longitudinal forces (Fx), transversal forces (Fy), and the self-alignment torque (Mz), **in that** the modeling operations also comprise the definition, as the second model, of a local heating model expressing variations of a contact temperature of the tread with the ground from the entrance to the exit of the contact area following contact and slip of the tread with the ground, and the definition, as the third model, of an overall heating and thermal flow model, said third model expressing variations, over a period of at least one revolution, of a peripheral temperature of the tread and an internal temperature of the tire as a function of previously known or estimated values of the peripheral and internal temperatures, a thermal conduction coefficient of the tread, and thermodynamic component phenomena such as internal deformations experienced by the tire, heat exchanges between the tire and the environment thereof, and slip of the tread on the ground, **in that** at least the adherence coefficient and the shear modulus are involved in the first model as variables or functions of the peripheral temperature and internal temperature, **in that** the peripheral temperature value (Ts), obtained by means of resolution operations relating to the third model, is used by resolution operations relating to the second model to account for the temperature dependency of the adherence coefficient, and **in that** the internal temperature value (Ti), obtained by means of resolution operations relating to the third model, is used by resolution operations relating to the first model to account for the temperature dependency of the shear modulus of the tire rubber.

9. Simulation method according to claim 8, **characterized in that** the first model includes equations associated with the equilibrium conditions of the basic shearing and slipping forces of the tread in the contact area, **in that** said method comprises at least one iterative calculation phase consisting of a succession of calculation cycles, and that each calculation cycle comprises at least one resolution operation relating to the second model.

10. Simulation method according to claim 9, **characterized in that** the first model is defined by considering that the contact area comprises a single adherent contact zone and a single slippery contact zone separated from each other by a transition point, **in that** the first model takes the form of a system of equations expressed at least as a function of the dynamic parameters, specific parameters, and the abscissa (b) of the transition point, **in that** each iterative phase is dedicated to phenomena occurring during a corresponding basic time interval, and **in that** each iterative phase is implemented to resolve, by means of successive approximations and at least on the basis of previously known or estimated values of the abscissa (bo) of the transition point, transversal forces (Fyo), and the self-alignment torque (Mzo), new values of the abscissa (b) of the transition point, transversal forces (Fy), and the self-alignment torque (Mz) which resolve the system of equations of the first model for the value attributed to the dynamic parameters and the specific parameters, with the result that the longitudinal forces, transversal forces, and the self-alignment torque of the tire may be calculated in real time during the driving of the vehicle.

11. Simulation method according to claim 10, **characterized in that** each new calculation cycle of each iterative phase comprises operations (9) consisting at least of:

- calculating a new provisional value of the abscissa of the transition point on the basis of the equilibrium equations of the basic forces and the previously known or estimated values of the transversal forces and the self-alignment torque;
- calculating, on the basis of the new provisional value of the abscissa of the transition point and the equations linking the transversal forces and the self-alignment torque with the dynamic parameters, specific parameters, and the abscissa of the transition point, new values of the transversal forces and the self-alignment torque that can be used for any subsequent calculation cycle;
- conditionally interrupting (10) said iterative phase at least when the difference between the new provisional value of the abscissa of the transition point and the previously known or estimated value of said abscissa is less than a predefined limit of precision; and
- when said iterative phase is interrupted, assigning (12) the longitudinal and transversal forces and the self-alignment torque, as the values for this phase, the new values of the longitudinal and transversal forces and the self-alignment torque obtained in the final calculation cycle.

**12.** Simulation method according to claim 10, **characterized in that** it further comprises an implementation operation after the end of each iterative phase and consisting of at least updating (4) the dynamic parameters to account for the variations experienced by said parameters during the iterative phase execution time, and initiating a new iterative phase (8-10).

**13.** Simulation method according to claim 8, **characterized in that** the resolution operations relating to the third model are performed outside each iterative phase.

**14.** Method according to claim 8, **characterized in that** each of the first, second and third models are processed for each tire and associated with a dynamic chassis model, **in that** the chassis model provides the first, second and third models, for each tire, with the values of at least some of the dynamic parameters, and that the chassis model processes, for each tire, the values of the longitudinal forces, transversal forces and the self-alignment torque obtained using the first, second and third models.

**Patentansprüche**

**1.** Verfahren zur Auswahl, aus einer Gruppe von möglichen Konfigurationen, einer optimierten Konfiguration von Reifen zum Bestücken eines Fahrzeugs, das dazu bestimmt ist, auf einer Rennstrecke zu fahren, indem es einer vorbestimmten Bahn folgt, die in einer einzigen Richtung ausgerichtet ist und Kurven enthält, wobei dieses Verfahren mindestens die Schritte enthält, die in einem Computer ausgeführt werden und darin bestehen:

- ein physikalisches Modell des mit einer ersten Reifenkonfiguration ausgestatteten Fahrzeugs zu entwickeln;
- ein digitales Bild der Bahn in aufeinanderfolgende Abschnitte aufzuteilen, die an Punkten miteinander verbunden sind, denen Grenzwerte der Geschwindigkeit des Fahrzeugs zugeordnet sind;
- durch Iterationen die Durchfahrt, durch das modellisierte Fahrzeug, jedes Bahnabschnitts, zuerst mit maximaler Beschleunigung in Bahnteilen, die nacheinander in der realen Durchfahrrichtung durchfahren werden und zu einem ersten Abschnittsbereich gehören, der einen Anfangspunkt dieses Abschnitts enthält, dann mit maximaler Verlangsamung in Bahnteilen zu simulieren, die nacheinander der eine vor dem anderen durchfahren werden und zu einem zweiten Abschnittsbereich gehören, der einen Endpunkt dieses Abschnitts enthält, und indem der erste und der zweite Abschnittsbereich an einem Punkt des Abschnitts miteinander verbunden werden, wo die Geschwindigkeit des modellisierten Fahrzeugs im ersten Bereich dieses Abschnitts die Geschwindigkeit des modellisierten Fahrzeugs im zweiten Bereich dieses Abschnitts nicht überschreitet;
- die Fahrzeit zu speichern, die das Fahrzeug benötigt, um die Bahn mindestens einmal zu durchfahren;
- die Fahrzeit mit mindestens einer Bezugszeit zu vergleichen und ein Vergleichsergebnis zu erzeugen; und
- abhängig vom Vergleichsergebnis die erste Konfiguration als optimierte Konfiguration auszuwählen oder nicht.

**2.** Verfahren nach Anspruch 1, **dadurch gekennzeichnet, dass** das Modell des Fahrzeugs ein thermomechanisches Modell der dieses Fahrzeug bestückenden Reifen enthält.

**3.** Verfahren nach einem der vorhergehenden Ansprüche, **dadurch gekennzeichnet, dass** es die Schritte enthält, die darin bestehen:

EP 2 100 245 B1

(a)eine Gruppe von physikalischen Parametern zahlenmäßig zu erfassen, die dahin tendieren, die vom Fahrzeug auf der Bahn angenommene Geschwindigkeit zu begrenzen, wobei diese Gruppe konstante Parameter und dynamische Parameter enthält, wobei diese Parameter mit den verschiedenen möglichen Reifen, mit dem Fahrgestell des Fahrzeugs und/oder mit den Fahrbedingungen verbunden sind und ein digitales Bild der Bahn enthalten, das aus digitalisierten Koordinaten von aufeinanderfolgenden Punkten dieser Bahn besteht;

(b)ein Reifenmodell zu entwickeln, das das physikalische Verhalten jedes Reifens beschreibt und eine erste Teilgruppe der Gruppe von physikalischen Parametern einsetzt;

(c)ein Fahrzeugmodell zu entwickeln, das sowohl das Reifenmodell als auch eine zweite Teilgruppe der Gruppe von physikalischen Parametern einsetzt und das physikalische Verhalten des Fahrzeugs in Abhängigkeit mindestens von den Beanspruchungen der Reifen beschreibt, wobei diese Beanspruchungen Schlüpfe und Driften enthalten;

(d)das digitale Bild der Bahn in benachbarte Abschnitte aufzuteilen, die in Fahrtrichtung aufeinander folgen und von denen jeder eine Gruppe von mindestens drei Bahnpunkten enthält, die einen Anfangspunkt und einen Endpunkt umfassen und in dieser Reihenfolge in Fahrtrichtung aufeinander folgen, wobei der Endpunkt sich in einer Kurveneinfahrt befindet;

(e)dem Anfangspunkt bzw. dem Endpunkt jedes Abschnitts Grenzwerte der Geschwindigkeit des Fahrzeugs zuzuordnen;

(f)als aktive Konfiguration eine erste Reifenkonfiguration zu wählen;

(g)als aktiven Abschnitt einen ersten Bahnabschnitt zu wählen;

(h)mittels des Fahrzeugmodells die Durchfahrt mindestens eines ersten Bereichs des aktiven Bahnabschnitts ausgehend von seinem Anfangspunkt durch das mit der aktiven Reifenkonfiguration ausgestattete Fahrzeug zu simulieren, indem die Beanspruchungen der Reifen optimiert werden, um die vom Fahrzeug erfahrene Beschleunigung ausgehend von der dem Anfangspunkt dieses aktiven Abschnitts zugeordneten Grenzgeschwindigkeit zu maximieren;

(i)die Geschwindigkeiten des Fahrzeugs an den verschiedenen Punkten des ersten Bereichs des aktiven Abschnitts und die Fahrzeiten zwischen diesen verschiedenen Punkten zu speichern;

(j)als aktiven Teilabschnitt des aktiven Abschnitts den Bahnteil auszuwählen, der zwischen einem ersten und einem zweiten Punkt eines Paars von einander in dieser Reihenfolge in Fahrtrichtung folgenden Punkten des aktiven Abschnitts definiert ist, wobei der zweite Punkt dieses Paars aus dem Endpunkt des aktiven Abschnitts besteht;

(k)als Zielgeschwindigkeit die dem zweiten Punkt des aktiven Teilabschnitts zugeordnete Grenzgeschwindigkeit zu wählen;

(1) mittels des Fahrzeugmodells die Durchfahrt des aktiven Teilabschnitts des aktiven Abschnitts durch das mit der aktiven Reifenkonfiguration ausgestattete Fahrzeugs zu simulieren, indem die Beanspruchungen der Reifen und die vom Fahrzeug am ersten Punkt des aktiven Teilabschnitts angenommene Geschwindigkeit zum Erreichen des zweiten Punkts des aktiven Teilabschnitts mit der Zielgeschwindigkeit optimiert werden, bei gleichzeitiger Minimierung der Fahrzeit in diesem aktiven Teilabschnitt;

(m)die Durchfahrzeit des aktiven Teilabschnitts durch das Fahrzeug zu speichern; als Grenzgeschwindigkeit die Geschwindigkeit des Fahrzeugs am ersten Punkt des aktiven Teilabschnitts zu speichern; und als Element eines zweiten Bereichs des aktiven Abschnitts den durchfahrenen aktiven Teilabschnitt zu speichern;

(n)zu überprüfen, ob die Grenzgeschwindigkeit des Fahrzeugs am ersten Punkt des aktiven Teilabschnitts die im Schritt (i) gespeicherte Geschwindigkeit überschreitet oder nicht, die an diesem gleichen Punkt vom Fahrzeug bei der Durchfahrt des ersten Bereichs des aktiven Abschnitts angenommen wird;

(o)wenn nicht, als neuen aktiven Teilabschnitt des aktiven Abschnitts einen bezüglich der Fahrtrichtung vorne befindlichen Bahnteil des chronologisch vorhergehenden aktiven Teilabschnitts auszuwählen, der zwischen einem ersten und einem zweiten Punkt eines Paars von Punkten des aktiven Abschnitts definiert ist, die in dieser Reihenfolge in Fahrtrichtung aufeinander folgen, wobei der zweite Punkt dieses Paars aus dem ersten Punkt des chronologisch vorhergehenden aktiven Teilabschnitts besteht, und die Schritte (k) bis (n) zu wiederholen;

(p)wenn ja, als Gesamtdurchfahrzeit des aktiven Abschnitts die Summe der Gesamtdurchfahrzeit im zweiten Bereich dieses aktiven Abschnitts und der über den Bruchteil des ersten Bereichs dieses Abschnitts, der den zweiten Bereich nicht abdeckt, gespeicherten Fahrzeiten zu speichern;

(q)als neuen aktiven Abschnitt den Bahnabschnitt auszuwählen, der auf den vorher aktiven Abschnitt in Fahrtrichtung folgt;

(r)die Schritte (h) bis (q) zu wiederholen, bis die Bahn mindestens ein Mal durchfahren ist und eine kumulierte und stabilisierte Durchfahrzeit der Bahn durch das Fahrzeug erhalten wird.

4. Verfahren nach Anspruch 3, **dadurch gekennzeichnet, dass** es außerdem die Schritte enthält, die darin bestehen:

(s) als neue aktive Konfiguration eine zweite Reifenkonfiguration auszuwählen;

(t) die Schritte (g) bis (r) zu wiederholen;

(u) die kumulierten und stabilisierten Durchfahrzeiten der Bahn, die mit der ersten bzw. der zweiten Reifenkonfiguration erhalten wurden, zu vergleichen; und

(v) als optimierte Konfiguration die Reifenkonfiguration auszuwählen, die zur kürzesten kumulierten und stabilisierten Durchfahrzeit der Bahn führt, wobei die mit jeder Reifenkonfiguration erhaltene Durchfahrzeit so als Bezugszeit für die mit der anderen Reifenkonfiguration erhaltene Durchfahrzeit dient.

**5.** Verfahren nach einem der Ansprüche 3 und 4, **dadurch gekennzeichnet, dass** das Reifenmodell ein thermodynamisches Modell ist, dass vor dem Schritt (j) ein Schritt (w0) liegt, der darin besteht, als aktive thermische Bedingungen vorbestimmte thermische Bedingungen auszuwählen, dass der Schritt (1) durchgeführt wird, indem die aktiven thermischen Bedingungen an die Reifen angewendet werden, dass der Schritt (m) den zusätzlichen elementaren Vorgang enthält, der darin besteht, die Beanspruchungen der Reifen in jedem aktiven Teilabschnitt zu speichern, und dass direkt vor dem Schritt (p) eine Iterationsschleife liegt, die die Schritte enthält, die darin bestehen:

(w1) im Fall des Erfolgs der im Schritt (n) durchgeführten Überprüfung mittels des Fahrzeugmodells die Durchfahrt dieses mit der aktiven Reifenkonfiguration bestückten Fahrzeugs, aktiver Teilabschnitt nach aktivem Teilabschnitt in Fahrtrichtung, durch den zweiten Bereich des aktiven Abschnitts zu simulieren, indem an die Reifen in jedem aktiven Teilabschnitt die im Schritt (m) für diesen aktiven Teilabschnitt gespeicherten Beanspruchungen angewendet werden, und davon neue thermische Benutzungsbedingungen der Reifen im zweiten Bereich des aktiven Abschnitts abzuleiten;

(w2) zu überprüfen, ob die Abweichung zwischen den neuen thermischen Bedingungen und den aktiven thermischen Bedingungen innerhalb einer Konvergenzgrenze liegt oder nicht; und

(w3) wenn nicht, als aktive thermische Bedingungen die neuen thermischen Bedingungen zu speichern und die Schritte (j) bis (w2) zu wiederholen.

**6.** Verfahren nach einem der Ansprüche 3 bis 5, **dadurch gekennzeichnet, dass** der Schritt (d) durchgeführt wird, indem der Endpunkt jedes Abschnitts im Krümmungsmaximum einer Kurve fixiert wird.

**7.** Verfahren nach einem der Ansprüche 3 bis 6, **dadurch gekennzeichnet, dass** es einen zusätzlichen Vorgang enthält, der bei jeder neuen Durchfahrt der Bahn durchgeführt wird und darin besteht, den Endpunkt jedes Abschnitts nach vorne in Richtung einer Zone geringeren Schlupfs der Reifen zu verschieben.

**8.** Verfahren nach einem der Ansprüche 3 bis 7, **dadurch gekennzeichnet, dass** das im Schritt (b) entwickelte Reifenmodell das physikalische Verhalten jedes das Fahrzeug bestückenden Reifens in der Situation des Rollens auf dem Boden beschreibt, mit dem die Lauffläche des Reifens einen Kontaktbereich aufweist, der mindestens eine Zone eines Kraftschlusskontakts und mindestens eine Zone eines Schlupfkontakts umfasst, dass der Schritt (b) mindestens Vorgänge der Modellbildung enthält, dass jeder Simulationsschritt (h, 1, w1) Vorgänge der Zuweisung von digitalen Werten und Auflösungsvorgänge enthält, wobei die Vorgänge der Modellbildung mindestens darin bestehen, durch Anwendung bekannter und/oder durch spezifische Versuche konstruierter physikalischer Gesetze, und als erstes Modell, ein Modell der Längskräfte (Fx), der Querkräfte (Fy) und eines Selbstrückstellmoments (Mz), das von den Reifen zwischen dem Boden und dem Fahrzeug übertragen wird, in Abhängigkeit von spezifischen physikalischen Parametern, die einen Kraftschlusskoeffizient und ein Schermodul des Gummis des Reifens enthalten, und in Abhängigkeit von dynamischen Parametern zu erstellen, die mit den physikalischen Fahr- und Nutzungsbedingungen des Reifens verbunden sind, wobei das Selbstrückstellmoment mit der Stärke der Längs- und Querkräfte und ihrer Verteilung im Kontaktbereich verbunden ist, wobei die Zuweisungsvorgänge mindestens darin bestehen, den dynamischen Parametern (4) und den spezifischen Parametern (5) digitale Werte zuzuordnen, und die Auflösungsvorgänge mindestens darin bestehen, unter Verwendung mindestens des ersten Modells und der den dynamischen Parametern und den spezifischen physikalischen Parametern zugeordneten Werte Werte der Längskräfte (Fx), der Querkräfte (Fy) und des Selbstrückstellmoments (Mz) abzuleiten, dass die Modellbildungsvorgänge ebenfalls die Erstellung, als zweites Modell, eines lokalen Erwärmungsmodells enthalten, das Veränderungen einer Kontakttemperatur der Lauffläche mit dem Boden vom Eingang bis zum Ausgang des Kontaktbereichs aufgrund des Kontakts und des Schlupfs der Lauffläche mit dem Boden, und die Erstellung, als drittes Modell, eines globalen Modells der Erwärmung und des Wärmeflusses enthalten, wobei dieses dritte Modell Veränderungen, in einer Periode von mindestens einer Radumdrehung, einer Umfangstemperatur der Lauffläche und einer Innentemperatur des Reifens in Abhängigkeit von vorher bekannten oder geschätzten Werten der Umfangs- und Innentemperaturen, von einem Wärmeleitkoeffizienten der Lauffläche und von Phänomenen mit thermodynamischer Komponente wie vom Reifen erfahrene innere Verformungen, Wärmeaustauschvorgänge zwischen dem Reifen und seiner Umgebung und Schlupf der Lauffläche auf dem Boden ausdrückt, dass mindestens der Kraftschlusskoeffizient und das Schermodul im ersten Modell als Variable bzw. Funktionen der Umfangstemperatur und der Innentemperatur vorkommen, dass der Wert der Umfangstemperatur (Ts), der durch zum dritten Modell gehörende Auflösungsvorgänge erhalten wird, von zum zweiten Modell gehörenden Auflösungsvorgängen verwendet wird, um die Temperaturabhängigkeit des Kraftschlusskoeffizienten zu berücksichtigen, und dass der Wert der Innentemperatur (Ti), der durch zum dritten Modell gehörende Auflösungsvorgänge erhalten wird, von zum ersten Modell gehörenden Auflösungsvorgängen verwendet wird, um die Temperaturabhängigkeit des Schermoduls des Gummis des Reifens zu berücksichtigen.

9. Simulationsverfahren nach Anspruch 8, **dadurch gekennzeichnet, dass** das erste Modell Gleichungen enthält, die mit Gleichgewichtsbedingungen der elementaren Scher- und Schlupfkräfte der Lauffläche im Kontaktbereich verbunden sind, dass das Verfahren mindestens eine iterative Berechnungsphase enthält, die aus einer Folge von Berechnungszyklen besteht, und dass jeder Berechnungszyklus mindestens einen zum ersten Modell gehörenden Auflösungsvorgang und einen zum zweiten Modell gehörenden Auflösungsvorgang enthält.

10. Simulationsverfahren nach Anspruch 9, **dadurch gekennzeichnet, dass** das erste Modell erstellt wird, indem angenommen wird, dass der Kontaktbereich eine einzige Kraftschluss-Kontaktzone und eine einzige Schlupf-Kontaktzone enthält, die voneinander durch einen Übergangspunkt getrennt sind, dass das erste Modell die Form eines Systems von Gleichungen annimmt, die mindestens in Abhängigkeit von den dynamischen Parametern, den spezifischen Parametern und der Abszisse (b) des Übergangspunkts ausgedrückt werden, dass jede iterative Phase Phänomenen dediziert ist, die während eines entsprechenden Elementarzeitintervalls auftreten, und dass jede iterative Phase durchgeführt wird, um durch aufeinanderfolgende Näherungen und mindestens ausgehend von vorher bekannten oder geschätzten Werten der Abszisse (bo) des Übergangspunkts, der Querkräfte (Fyo) und des Selbstrückstellmoments (Mzo) neue Werte der Abszisse (b) des Übergangspunkts, der Querkräfte (Fy) und des Selbstrückstellmoments (Mz) aufzulösen, die das Gleichungssystem des ersten Modells für die Werte auflösen, die den dynamischen und den spezifischen Parametern zugeteilt sind, woraus resultiert, dass die Längskräfte, die Querkräfte und das Selbstrückstellmoment des Reifens während der Fahrt des Fahrzeugs in Echtzeit berechnet werden können.

11. Simulationsverfahren nach Anspruch 10, **dadurch gekennzeichnet, dass** jeder neue Berechnungszyklus jeder iterativen Phase die Vorgänge (9) enthält, die mindestens darin bestehen:

- einen neuen provisorischen Wert der Abszisse des Übergangspunkts ausgehend von den Gleichgewichtsgleichungen der Elementarkräfte und der vorher bekannten oder geschätzten Werte der Querkräfte und des Selbstrückstellmoments zu berechnen;
- ausgehend von dem neuen provisorischen Wert der Abszisse des Übergangspunkts und von den Gleichungen, die die Querkräfte und das Selbstrückstellmoment mit den dynamischen Parametern, den spezifischen Parametern und mit der Abszisse des Übergangspunkts verbinden, neue Werte der Querkräfte und des Selbstrückstellmoments zu berechnen, die für einen möglichen späteren Berechnungszyklus verwendbar sind;
- bedingt (10) die iterative Phase mindestens dann zu unterbrechen, wenn die Abweichung zwischen dem neuen provisorischen Wert der Abszisse des Übergangspunkts und dem vorher bekannten oder geschätzten Wert dieser Abszisse unter einer vorbestimmten Präzisionsgrenze liegt; und
- bei Unterbrechung der iterativen Phase den Längs- und Querkräften und dem Selbstrückstellmoment als Werte für diese Phase die neuen Werte der Längs- und Querkräfte und des Selbstrückstellmoments zuzuteilen (12), die während des letzten Berechnungszyklus erhalten wurden.

12. Simulationsverfahren nach Anspruch 10 oder 11, **dadurch gekennzeichnet, dass** es außerdem einen Anwendungsvorgang nach dem Ende jeder iterativen Phase enthält, der darin besteht, mindestens die dynamischen Parameter zu aktualisieren (4), um die Entwicklungen zu berücksichtigen, die diese Parameter während der Ausführungszeit der iterativen Phase erfahren haben, und eine neue iterative Phase (8-10) einzuleiten.

13. Simulationsverfahren nach einem der Ansprüche 8 bis 12, **dadurch gekennzeichnet, dass** die zum dritten Modell gehörenden Auflösungsvorgänge außerhalb jeder iterativen Phase durchgeführt werden.

14. Verfahren nach einem der Ansprüche 8 bis 13, **dadurch gekennzeichnet, dass** jedes der ersten, zweiten und dritten Modelle für jeden Reifen ausgewertet und einem dynamischen Fahrgestellmodell zugeordnet wird, dass das Fahrgestellmodell dem ersten, zweiten und dritten Modell für jeden Reifen die Werte zumindest bestimmter der dynamischen Parameter liefert, und dass das Fahrgestellmodell für jeden Reifen die Werte der Längskräfte, der Querkräfte und des Selbstrückstellmoments auswertet, die durch die Anwendung des ersten, zweiten und dritten Modells erhalten werden.

FIG. 1

FIG. 3

a, b, c, d, e, f

g

h

i, w0

j

k

l, m

o

n
Raccord de P1_TA et P2_TA?
OUI
NON

w1

w3

w2
Convergence thermique sur P2_TA?
OUI
NON

p, q

r

s

t

u, v

FIG. 2

FIG. 4

FIG. 5

FIG. 6

FIG. 7

Centre de l'aire de
contact déportée

Centre de l'aire de
contact non déportée

Jante

Déport
transversal
$d_Y$

Pneu non
déporté

Sol

Pneu déporté
transversalement

Effort transversal

## FIG. 8

Centre de l'aire de
contact non déportée

Centre de l'aire de
contact déportée

Pneu non
déporté

Déport
longitudinal
$d_X$

Pneu déporté
longitudinalement

Application d'un effort
longitudinal $F_X$

## FIG. 9

FIG. 10

**Grandeurs dynamiques d'entrée**

| Taux de glissement |
|---|
| Angle de dérive |
| Angle de carrossage |
| Charge |
| Vitesse |
| Pression de gonflage |
| Température de l'air |
| Température du sol |
| Temps |
| Températures initiales du pneu |

- Equations de la mécanique & thermique pneu

- Méthode de calcul temps réel

Paramètres spécifiques d'entrée

**Grandeurs de sortie**

| Effort longitudinal |
|---|
| Effort latéral |
| Couple d'auto-alignement |
| Température interne de la gomme |
| Température de surface du pneu |

## FIG. 11

FIG. 12

FIG. 13

FIG. 14

FIG. 15

Convection avec l'air

Conduction thermique
dans la gomme

sol

Frottement du sol

Conduction avec le sol

Auto-échauffement de la
bande de roulement lié aux
pertes internes

FIG. 16

FIG. 17

FIG. 18a

Modèle thermique global

| Paramètres dynamiques | Paramètres spécifiques | Sorties du modèle mécanique |
|---|---|---|
| $\overline{Fz, \delta, y, g, V, Pg, Tair,}$ Tsol | $\overline{R_L, R_{LL}, kT, S2, ...}$ | $\overline{Fx, Fy,}$ longueur glissée, efforts de frottement ... |

Profil de température de la gomme $T^{n-1}$

Calcul des termes d'échange à la surface du pneu:
- flux de convection avec l'air
- flux de conduction avec le sol
- flux de frottement gomme/sol

Calcul des temps caractéristiques des termes d'échange à la surface du pneu:
- Temps d'échange par convection avec l'air
- Temps d'échange par conduction avec le sol
- Temps d'application du flux de frottement gomme/sol

Calcul du flux moyen à la surface du pneu sur un tour de roue

Calcul de la puissance dissipée dans la gomme liée au cisaillement maximum dans l'aire de contact

Calcul de flux de chaleur à l'interface gomme / nappes sommet

Résolution de l'équation de la chaleur dans l'épaisseur de la gomme.

Sorties :
Profil de température de la gomme $T^{n}$
Température de surface $Ts^{n}$
Température moyenne $Tm^{n}$

FIG. 18b

FIG. 19

**EP 2 100 245 B1**